(19) **Europäisches Patentamt European Patent Office Office européen des brevets**

(11) **EP 3 920 251 B1**

(12) **EUROPEAN PATENT SPECIFICATION**

(45) Date of publication and mention
of the grant of the patent:
**08.07.2026 Bulletin 2026/28**

(21) Application number: **21172213.7**

(22) Date of filing: **05.05.2021**

(51) International Patent Classification (IPC):
$H10K\ 50/115^{(2023.01)}$    $H10K\ 59/35^{(2023.01)}$
$H10K\ 50/17^{(2023.01)}$    $H10K\ 50/852^{(2023.01)}$
$H10K\ 50/15^{(2023.01)}$    $H10K\ 102/00^{(2023.01)}$
$H10K\ 59/80^{(2023.01)}$    $H10K\ 50/16^{(2023.01)}$
$H10K\ 50/818^{(2023.01)}$    $H10K\ 50/828^{(2023.01)}$

(52) Cooperative Patent Classification (CPC):
**H10K 59/35; H10K 50/115; H10K 50/15;**
**H10K 50/17; H10K 50/852; H10K 59/876;**
H10K 50/16; H10K 50/171; H10K 50/818;
H10K 50/828; H10K 59/80518; H10K 59/80524;
H10K 2102/3026; H10K 2102/351

(54) **QUANTUM DOT DEVICE AND QUANTUM DOT DISPLAY DEVICE**

QUANTENPUNKTVORRICHTUNG UND QUANTENPUNKTANZEIGEVORRICHTUNG

DISPOSITIF À POINTS QUANTIQUES ET DISPOSITIF D'AFFICHAGE À POINTS QUANTIQUES

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **02.06.2020 KR 20200066616**

(43) Date of publication of application:
**08.12.2021 Bulletin 2021/49**

(60) Divisional application:
**26177995.3 / 4 770 363**

(73) Proprietors:
• **Samsung Electronics Co., Ltd.**
**Suwon-si, Gyeonggi-do 16677 (KR)**
• **Samsung Display Co., Ltd.**
**Yongin-si, Gyeonggi-do 17113 (KR)**

(72) Inventors:
• **CHUNG, Dae Young**
**Gyeonggi-do (KR)**
• **SEO, Hongkyu**
**Gyeonggi-do (KR)**
• **LEE, Yeonkyung**
**Gyeonggi-do (KR)**
• **JANG, Eun Joo**
**Gyeonggi-do (KR)**

(74) Representative: **Elkington and Fife LLP**
**Prospect House**
**8 Pembroke Road**
**Sevenoaks, Kent TN13 1XR (GB)**

(56) References cited:
**EP-A1- 3 656 833**    **CN-A- 110 400 890**

• **LIU SHIHAO ET AL: "Top-emitting quantum dots**
**light-emitting devices employing microcontact**
**printing with electricfield-independent**
**emission", SCIENTIFIC REPORTS, vol. 6, no. 1, 2**
**March 2016 (2016-03-02), XP055821260, DOI:**
**10.1038/srep22530**
• **LIU GUOHONG ET AL: "Very Bright and Efficient**
**Microcavity Top-Emitting Quantum Dot Light-**
**Emitting Diodes with Ag Electrodes", APPLIED**
**MATERIALS & INTERFACES, vol. 8, no. 26, 24**
**June 2016 (2016-06-24), US, pages 16768 - 16775,**
**XP055846389, ISSN: 1944-8244, DOI: 10.1021/**
**acsami.6b03367**
• **LI DONG ET AL: "Enhanced Efficiency of InP-**
**Based Red Quantum Dot Light-Emitting Diodes",**
**APPLIED MATERIALS & INTERFACES, vol. 11,**
**no. 37, 23 August 2019 (2019-08-23), US, pages**
**34067 - 34075, XP055832908, ISSN: 1944-8244,**
**DOI: 10.1021/acsami.9b07437**

- WHALEN M. S. ET AL: "Index of refraction of n -type InP at 0.633- and 1.15-[mu]m wavelengths as a function of carrier concentration", JOURNAL OF APPLIED PHYSICS, vol. 53, no. 6, 1 June 1982 (1982-06-01), US, pages 4340 - 4343, XP055847125, ISSN: 0021-8979, DOI: 10.1063/1.331213

- ZHANG DONG-YAN ET AL: "First-principles simulation and experimental evidence for improvement of transmittance in ZnO films", PROGRESS IN NATURAL SCIENCE, vol. 21, no. 1, 16 March 2012 (2012-03-16), pages 40 - 45, XP028908243, ISSN: 1002-0071, DOI: 10.1016/S1002-0071(12)60023-9

**Description**

FIELD OF THE INVENTION

A quantum dot device and a quantum dot display device are disclosed.

BACKGROUND OF THE INVENTION

Unlike bulk material, intrinsic physical characteristics (e.g., energy bandgaps, melting points, etc.) of nanoparticles may be controlled by changing the nanoparticle sizes. For example, semiconductor nanocrystal particles also known as quantum dots may be supplied with photoenergy or electrical energy and may emit light in a wavelength corresponding to sizes of the quantum dots. Accordingly, the quantum dots may be used as a light emitter configured to emit light of a predetermined wavelength.

Scientific report "Top-emitting quantum dots light-emitting devices employing microcontact printing with electricfield-independent emission" (Liu Shihao et Al), dated 2 March 2016, XP0055821260, discloses methods of improving characteristics such as color gamut and color stability of quantum dot displays.

Scientific report "Very bright and Efficient Microcavity Top-Emitting Quantum Dot Light-emitting Diodes with Ag Electordes" (Liu Guohong et Al), dated 24th June 2016, XP0055846389, discloses the impact of variation in cavity length, top Ag thickness and capping layers of a quantum dot device.

Scientific report "Enhanced Efficiency on In-P-Based Red Quantum Dot Light-Emitting Diodes" (Li Dong et Al), dated 23rd August 2019, XP055832908 discloses possible solutions relating to magnesium doping, high-photoluminescence quantum yield emitters and different quantum dot light emitting diode (QLED) display architectures.

Patent application CN 110 400 890 discloses solutions to the problem of considering both the optical and electrical properties of the traditional QLED at the same time.

SUMMARY OF THE INVENTION

Quantum dots may be used as a light emitter of a device, and have been the subject of recent research. However, quantum dots are different from a conventional light emitter, and thus a new method of improving performance of a quantum dot device is required.

An embodiment provides a quantum dot device capable of realizing improved performance.

Another embodiment provides a quantum dot display device including the quantum dot device.

According to the present invention, there is provided a quantum dot device according to claims 1 and 4, respectively.

In an embodiment, the quantum dots may include cadmium-free quantum dots, and a difference between a refractive index of the quantum dot layer and a refractive index of the electron auxiliary layer may be about 0.20 to about 1.0.

In an embodiment, the electron auxiliary layer may include alkaline earth metal-containing inorganic nanoparticles.

In an embodiment, a difference between the peak emission wavelength of the quantum dot layer and the peak emission wavelength of light passing through the cathode may be about $\pm 5$ nm.

In an embodiment, the FWHM of the emission spectrum of light passing through the cathode may be about 0.2 times to about 0.9 times of the FWHM of the emission spectrum of the quantum dot layer.

According to another embodiment, a quantum dot display device including the quantum dot device is provided.

In an embodiment, the thickness of the hole auxiliary layer of the red quantum dot device may be about 0.1 times to about 0.9 times or about 1.2 times to about 3 times of the thickness of the hole auxiliary layer of the blue quantum dot device.

In an embodiment, the thickness of the electron auxiliary layer of the blue quantum dot device and the thickness of the electron auxiliary layer of the red quantum dot device may be substantially equal.

In an embodiment, the thickness of the quantum dot layer of the blue quantum dot device and the thickness of the quantum dot layer of the red quantum dot device may be substantially equal.

In an embodiment, the quantum dots included in the quantum dot layer of the blue quantum dot device may include cadmium-free quantum dots, the quantum dots included in the quantum dot layer of the red quantum dot device may include cadmium-free quantum dots, and a difference between the refractive indexes of the quantum dot layer and the electron auxiliary layer of the blue quantum dot device and a difference between the refractive indexes of the quantum dot layer and the electron auxiliary layer of the red quantum dot device may be about 0.20 to about 1.0, respectively.

In an embodiment, the electron auxiliary layer of the blue quantum dot device and the electron auxiliary layer of the red quantum dot device may each include alkaline earth metal-containing inorganic nanoparticles.

In an embodiment, a difference between the peak emission wavelength of the quantum dot layer of the blue quantum dot device and the peak emission wavelength of the emission spectrum displayed by the blue quantum dot device may be about $\pm 5$ nm and a difference between the peak emission wavelength of the quantum dot layer of the red quantum dot device and the peak emission wavelength of the emission spectrum displayed by the red quantum dot device may be about $\pm 5$ nm.

In an embodiment, each of the blue quantum dot device and the red quantum dot device may further include an optical auxiliary layer on the cathode, and the thicknesses of the optical auxiliary layers included in the blue quantum dot device and the red quantum dot device may be substantially equal.

The performance of the quantum dot device may be improved.

BRIEF DESCRIPTION OF THE DRAWINGS

FIG. 1 is a schematic cross-sectional view showing a quantum dot device according to an embodiment,
FIG. 2 is a schematic view showing an example of a quantum dot display panel of a quantum dot display device according to an embodiment,
FIG. 3 is a cross-sectional view of the quantum dot display panel of FIG. 2 taken along line III-III,
FIG. 4 is a graph showing a change in luminance according to the thickness of a hole auxiliary layer of a blue quantum dot device,
FIG. 5 is a graph showing a change in luminance according to the thickness of an electron auxiliary layer of a blue quantum dot device,
FIG. 6 is a graph showing a change in luminance according to the thickness of a hole auxiliary layer of a red quantum dot device, and
FIG. 7 is a graph showing a change in luminance according to the thickness of an electron auxiliary layer of a red quantum dot device.

DETAILED DESCRIPTION OF THE EMBODIMENTS

Hereinafter, example embodiments of the present disclosure will be described in detail so that a person skilled in the art would understand the same. This disclosure may, however, be embodied in many different forms and is not construed as limited to the example embodiments set forth herein.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10% or 5% of the stated value.

Hereinafter, the term "combination" includes a mixing and a stacked structure of two or more.

Hereinafter, the value of the work function, the HOMO energy level, or the LUMO energy level is expressed as an absolute value from a vacuum level. Also, when the work function, the HOMO energy level, or the LUMO energy level is deep, high, or large, it means that the absolute value is large with the vacuum level set to "0 eV," and when the work function, the HOMO energy level, or the LUMO energy level is shallow, low, or small, it means that the absolute value is small with the vacuum level set to "0 eV."

Hereinafter, a quantum dot device according to an embodiment will be described with reference to the drawings.

The quantum dot device according to an embodiment may be a quantum dot electroluminescent device configured to emit light from the quantum dot by applying an electric field to electrodes.

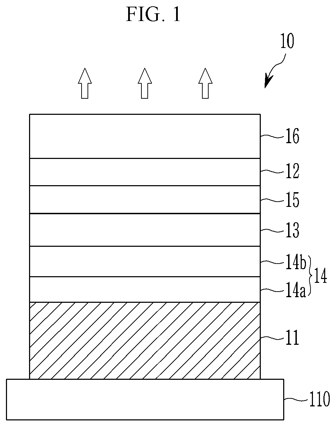

FIG. 1 is a schematic cross-sectional view showing a quantum dot device according to an embodiment.

Referring to FIG. 1, a quantum dot device 10 according to an embodiment includes an anode 11; a cathode 12; a quantum dot layer 13 disposed between the anode 11 and the cathode 12; and a hole auxiliary layer 14 disposed between an anode 11 and the quantum dot layer 13; an electron auxiliary layer 15 disposed between the cathode 12 and the quantum dot layer 13, and optionally an optical auxiliary layer 16.

The substrate 110 may be disposed under the anode 11. The substrate 110 may include a semiconductor substrate such as a silicon substrate; a glass substrate; or a polymer substrate such as polycarbonate, polymethyl methacrylate, polyethylene terephthalate, polyethylene naphthalate, polyamide, polyether sulfone, or a combination thereof, but is not limited thereto. The substrate 110 may be omitted.

The anode 11 may be a reflective electrode including a reflective layer.

As an example, the anode 11 may be formed of a reflective layer including an optically opaque material. The reflective layer may, for example, have a light transmittance of less than about 10%, for example, less than or equal to about 8%, less than or equal to about 7%, less than or equal to about 5%, less than or equal to about 3%, or less than or equal to about 1%. The reflective layer may have, for example, a reflectance of greater than or equal to about 10%, for example, greater than or equal to about 20%, greater than or equal to about 30%, greater than or equal to about 50%, or greater than or equal to about 70%. The optically opaque material may include a metal, a metal nitride, or a combination thereof, for example silver (Ag), copper (Cu), aluminum (Al), gold (Au), titanium (Ti), chromium (Cr) , Nickel (Ni), an alloy thereof, a nitride thereof (e.g., TiN), or a combination thereof, but is not limited thereto. The reflective layer may be one layer or two or more layers.

For example, the anode 11 may include a reflective layer including an optically opaque material and a light-transmitting layer including an optically transparent material. The reflective layer is as described above. The light-transmitting layer may have a high transmittance of greater than or equal to about 80%, greater than or equal to about 85%, greater than or equal to about 88%, or greater than or equal to about 90%, and may include an optically transparent conductor. The light-transmitting layer may include, for example, at least one of an oxide conductor, a carbon conductor, and/or a metal thin film. The oxide conductor may include for example at least one of indium tin oxide (ITO), indium zinc oxide (IZO), zinc tin oxide (ZTO), aluminum tin oxide (ATO), and aluminum zinc oxide (AZO), the carbon conductor may at least one of graphene and carbon nanostructures, and the metal thin film may be, for example, a metal thin film formed with a thickness of several nanometers to several tens of nanometers, or a single layer or a plurality of layers of metal thin film formed with a thickness of several nanometers to several tens of nanometers doped with metal oxide.

For example, the anode 11 may be formed of a reflective layer, or may have a stacked structure of reflective layer/light-transmitting layer or light-transmitting layer/reflective layer/light-transmitting layer.

The cathode 12 may face the anode 11 and may form a pair with the anode 11 to pass current to the quantum dot layer 13.

The cathode 12 may be a light-transmitting electrode configured to transmit at least a portion of light emitted from the quantum dot layer 13 to be described later. The light-transmitting electrode may include, for example, a light-transmitting layer, a semi-transmitting layer, or a combination thereof. Accordingly, the quantum dot device 10 may have a top emission structure in which light is emitted to the opposite side of the substrate 110, that is, toward the cathode 12.

The semi-transmitting layer may have a light transmittance between the light-transmitting layer and the reflective layer, and may have a light transmittance of about 10% to about 70%, about 20% to about 60%, or about 30% to about 50%. The semi-transmitting layer may, for example, be configured to selectively transmit light in a predetermined wavelength region and may be configured to reflect or absorb light in other wavelength regions. The semi-transmitting layer may include, for example, a metal layer or an alloy layer having a thin thickness of about 1 nm to about 50 nm, and may include, for example, silver (Ag), copper (Cu), aluminum (Al), magnesium (Mg), magnesium-silver (Mg-Ag), magnesium-aluminum (Mg-Al), or a combination thereof, but the present disclosure is not limited thereto.

The quantum dot layer 13 includes quantum dots. The quantum dots may be semiconductor nanocrystals, and may have various shapes, for example sphere semiconductor nanocrystals, quantum rods, or quantum plates. Herein, the quantum rod may be a quantum dot having an aspect ratio (length:width) of greater than about 1, for example an aspect ratio of greater than or equal to about 2, greater than or equal to about 3, or greater than or equal to about 5. For example, the quantum rod may have an aspect ratio of less than or equal to about 50, of less than or equal to about 30, or of less than or equal to about 20.

The quantum dots may have, for example a particle diameter (an average largest particle diameter for a non-spherical shape) of about 1 nm to about 100 nm, for example, about 1 nm to about 80 nm, for example, about 1 nm to about 50 nm, for example, about 1 nm to about 20 nm.

The quantum dots may control energy bandgaps according to sizes and/or compositions, and thus emission wavelengths thereof may be also controlled. For example, as the sizes of the quantum dots become larger, the energy bandgap may become narrower, and accordingly, light in a relatively long wavelength region may be emitted. as the sizes of the quantum dots become smaller, the energy bandgap may become wider and thus light in a relatively short wavelength region may be emitted.

For example, the quantum dots may be configured to emit for example light in a predetermined wavelength region of a visible light region according to its size and/or composition. For example, the quantum dots may be configured to emit any one of light in the blue wavelength spectrum (hereinafter referred to as "blue light"), light in the red wavelength spectrum (hereinafter referred to as "red light"), and light in the green wavelength spectrum (hereinafter referred to as "green light"). The blue light may have, for example, a peak emission wavelength (also referred to as emission peak wavelength) ($\lambda_{max}$) in about 430 nm to about 485 nm, the red light may have an emission peak wavelength ($\lambda_{max}$) in about 600 nm to about 680 nm, and the green light may have an emission peak wavelength ($\lambda_{max}$) in about 510 nm to about 570 nm.

For example, an average size of the quantum dots configured to emit blue light may be, for example, less than or equal to about 4.5 nm, and for example, less than or equal to about 4.3 nm, less than or equal to about 4.2 nm, less than or equal to about 4.1 nm, or less than or equal to about 4.0 nm. Within the above range, for example, the average size may be about 2.0 nm to 4.5 nm, for example, about 2.0 nm to about 4.3 nm, about 2.0 nm to about 4.2 nm, about 2.0 nm to about 4.1 nm, or about 2.0 nm to about 4.0 nm.

The quantum dots may have a relatively narrow full width at half maximum (FWHM). Herein, the FWHM is a width of a wavelength corresponding to a half of a peak absorption point and as the FWHM is narrower, light in a narrower wavelength region may be emitted and higher color purity may be obtained. The quantum dot may have, for example, a FWHM of less than or equal to about 50 nm, less than or equal to about 49 nm, less than or equal to about 48 nm, less than or equal to about 47 nm, less than or equal to about 46 nm, less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, less than or equal to about 35 nm, less than or equal to about 34 nm, less than or equal to about 33 nm, less than or equal to about 32 nm, less than or equal to about 31 nm, or less than or equal to about 30 nm. The quantum dots may have for example a FWHM of about 10 nm to 50 nm, about 10 nm to about 49 nm, about 10 nm to about 48 nm, about 10 nm to about 47 nm, about 10 nm to about 46 nm, about 10 nm to about 45 nm, about 10 nm to about 44 nm, about 10 nm to about 43 nm, about 10 nm to about 42 nm, about 10 nm to about 41 nm, about 10 nm to about 40 nm, about 10 nm to about 39 nm, about 10 nm to about 38 nm, about 10 nm to about 37 nm, about 10 nm to about 36 nm, about 10 nm to about 35 nm, about 10 nm to about 34 nm, about 10 nm to about 33 nm, about 10 nm to about 32 nm, about 10 nm to about 31 nm or about 10 nm to about 30 nm.

For example, the quantum dot may include a Group II-VI semiconductor compound, a Group III-V semiconductor compound, a Group IV-VI semiconductor compound, a Group IV semiconductor compound, a Group I-III-VI semiconductor compound, a Group I-II-IV-VI semiconductor compound, a Group II-III-V semiconductor compound, or a combination thereof.

As an example, the quantum dot may include a Cd-free quantum dot. The cadmium-free quantum dot is a quantum dot that does not include cadmium (Cd). Cadmium (Cd) may cause severe environment/health problems and a restricted element by Restriction of Hazardous Substances Directive (RoHS) in a plurality of countries, and thus the cadmium-free quantum dot may be effectively used. Since the cadmium-free quantum dot is different from the cadmium quantum dot, the quantum dot device 10 including the cadmium-free quantum dots is required a different configuration and design from the conventional devices including the cadmium quantum dot.

The Group II-VI semiconductor compound may include, for example, a binary semiconductor compound such as ZnS, ZnSe, ZnTe, ZnO, HgS, HgSe, HgTe, MgSe, MgS, or a mixture thereof; a ternary semiconductor compound such as ZnSeS, ZnSeTe, ZnSTe, HgSeS, HgSeTe, HgSTe, HgZnS, HgZnSe, HgZnTe, MgZnSe, MgZnS, or a mixture thereof; and a quaternary semiconductor compound such as HgZnTeS, HgZnSeS, HgZnSeTe, HgZnSTe, or a mixture thereof, but is not limited thereto. The Group III-V semiconductor compound may include, for example, a binary semiconductor compound such as GaN, GaP, GaAs, GaSb, AlN, AlP, AlAs, AlSb, InN, InP, InAs, InSb, or a mixture thereof; a ternary semiconductor compound such as GaNP, GaNAs, GaNSb, GaPAs, GaPSb, AlNP, AlNAs, AlNSb, AlPAs, AlPSb, InNP, InNAs, InNSb, InPAs, InPSb, or a mixture thereof; and a quaternary semiconductor compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or a mixture thereof, but not limited thereto. The Group IV-VI semiconductor compound may include, for example, a binary semiconductor compound such as SnS, SnSe, SnTe, PbS, PbSe, PbTe, or a mixture thereof; a ternary semiconductor compound such as SnSeS, SnSeTe, SnSTe, PbSeS, PbSeTe, PbSTe, SnPbS, SnPbSe, SnPbTe, or a mixture thereof; and a quaternary semiconductor compound such as SnPbSSe, SnPbSeTe, SnPbSTe, or a mixture thereof, but are not limited thereto. The Group IV semiconductor compound may include, for example, a single element semiconductor compound such as Si, Ge, or a mixture thereof; and a binary semiconductor compound such as SiC, SiGe, or a mixture thereof, but is not limited thereto. The Group I-III-VI semiconductor compound may include, for example, $CuInSe_2$, $CuInS_2$, CuInGaSe, CuInGaS, or mixture thereof, but is not limited thereto. The Group I-II-IV-VI semiconductor compound may include, for example, CuZnSnSe, CuZnSnS, or a mixture thereof, but is not limited thereto. The Group II-III-V semiconductor compound may include, for example, InZnP, but is not limited thereto.

The quantum dot may include the binary semiconductor compound, the ternary semiconductor compound, or the quaternary semiconductor compound in a substantially uniform concentration or partially different concentration distributions, for example as a continuous or step gradient.

As an example, the quantum dot may be a semiconductor compound including zinc (Zn) and at least one of tellurium (Te) and selenium (Se). For example, the quantum dot may be a Zn-Te semiconductor compound, a Zn-Se semiconductor compound, and/or a Zn-Te-Se semiconductor compound. For example, a content of tellurium (Te) in the Zn-Te-Se semiconductor compound may be smaller than a content of selenium (Se). The semiconductor compound may have a peak emission wavelength in a wavelength region of less than or equal to about 485 nm, for example, about 430 nm to about 485 nm, about 430 nm to about 480 nm, about 430 nm to about 475 nm or, about 430 nm to about 470 nm and may be configured to emit blue light.

As an example, the quantum dot may be a semiconductor compound including indium (In), phosphorus (P) and optionally zinc (Zn). For example, the quantum dot may be an In-P semiconductor compound and/or an In-Zn-P semiconductor compound. For example, in the In-Zn-P semiconductor compound, a mole ratio of zinc (Zn) to indium (In) may be greater than or equal to about 25. The semiconductor compound may have a peak emission wavelength in a wavelength region of less than about 700 nm, for example, about 600 nm to about 680 nm, and may be configured to emit red light.

The quantum dot may have a core-shell structure in which one quantum dot surrounds another quantum dot. For example, the core and the shell of the quantum dot may have an interface, and an element of at least one of the core or the shell in the interface may have a concentration gradient wherein the concentration of the element(s) of the shell decreases toward the core. For example, a material composition of the shell of the quantum dot has a higher energy bandgap than a material composition of the core of the quantum dot, and thereby the quantum dot may exhibit a quantum confinement effect.

The quantum dot may include one quantum dot core and a multi-layered quantum dot shell surrounding it. In this case, the multi-layered shell has two or more shells, and each layer may independently have a single composition, an alloy, and/or a concentration gradient. For example, a shell of a multi-shell that is far from the core may have a higher energy bandgap than a shell that is near to the core, and thereby the quantum dot may exhibit a quantum confinement effect.

For example, a quantum dot having a core-shell structure may include a core including a first semiconductor compound including zinc (Zn) and at least one of tellurium (Te) and selenium (Se), and a shell disposed on at least a portion of the core and including a second semiconductor compound having a composition different from the core.

For example, the first semiconductor compound may be a Zn-Te-Se-based semiconductor compound including zinc (Zn), tellurium (Te), and selenium (Se), for example, a Zn-Se-based semiconductor compound including a small amount of tellurium (Te), for example, a semiconductor compound represented by $ZnTe_xSe_{1-x}$, where x is greater than about 0 and less than or equal to about 0.05.

For example, in the Zn-Te-Se-based first semiconductor compound, a mole content of zinc (Zn) may be greater than a mole content of selenium (Se), and a mole content of selenium (Se) may be greater a mole content of tellurium (Te). For example, in the first semiconductor compound, a mole ratio of tellurium (Te) to selenium (Se) may be less than or equal to about 0.05, less than or equal to about 0.049, less than or equal to about 0.048, less than or equal to about 0.047, less than or equal to about 0.045, less than or equal to about 0.044, less than or equal to about 0.043, less than or equal to about 0.042, less than or equal to about 0.041, less than or equal to about 0.04, less than or equal to about 0.039, less than or equal to about 0.035, less than or equal to about 0.03, less than or equal to about 0.029, less than or equal to about 0.025, less than or equal to about 0.024, less than or equal to about 0.023, less than or equal to about 0.022, less than or equal to about 0.021, less than or equal to about 0.02, less than or equal to about 0.019, less than or equal to about 0.018, less than or equal to about 0.017, less than or equal to about 0.016, less than or equal to about 0.015, less than or equal to about 0.014, less than or equal to about 0.013, less than or equal to about 0.012, less than or equal to about 0.011, or less than or equal to about 0.01. For example, in the first semiconductor compound, a mole ratio of tellurium (Te) to zinc (Zn) may be less than or equal to about 0.02, less than or equal to about 0.019, less than or equal to about 0.018, less than or equal to about 0.017, less than or equal to about 0.016, less than or equal to about 0.015, less than or equal to about 0.014, less than or equal to about 0.013, less than or equal to about 0.012, less than or equal to about 0.011, or less than or equal to about 0.011.

The second semiconductor compound may include, for example, a Group II-VI semiconductor compound, a Group III-V semiconductor compound, a Group IV-VI semiconductor compound, a Group IV semiconductor compound, a Group I-III-VI semiconductor compound, Group I-II-IV-VI semiconductor compound, a Group II-III-V semiconductor compound, or a combination thereof. Examples of the Group II-VI semiconductor compound, Group III-V semiconductor compound, Group IV-VI semiconductor compound, Group IV semiconductor compound, Group I-III-VI semiconductor compound, Group I-II-IV-VI semiconductor compound, and Group II-III-V semiconductor compound are the same as described above.

For example, the second semiconductor compound may include zinc (Zn), selenium (Se), and/or sulfur (S). For example, the shell may include ZnSeS, ZnSe, ZnS, or a combination thereof. For example, the shell may include one or more inner shells disposed close to the core and an outermost shell disposed at the outermost side of the quantum dot, and the inner shell may include ZnSeS, ZnSe, or a combination thereof, and the outermost shell may include ZnS. For example, the shell may have a concentration gradient with respect to one component. For example, the shell may have a concentration gradient in which a content of sulfur (S) increases as being apart from the core.

For example, the quantum dot having a core-shell structure may include a core including a third semiconductor compound including indium (In), phosphorus (P) and optionally, zinc (Zn), and a shell disposed on at least a portion of the core and including a fourth semiconductor compound having a different composition from the core.

In the In-Zn-P-based third semiconductor compound, a mole ratio of zinc (Zn) to indium (In) may be greater than or equal to about 25. For example, the mole ratio of zinc (Zn) to indium (In) in the In-Zn-P-based third semiconductor compound may be greater than or equal to about 28, greater than or equal to about 29, or greater than or equal to about 30. For example, the mole ratio of zinc (Zn) to indium (In) in the In-Zn-P-based third semiconductor compound may be less than or equal to about 55, for example less than or equal to about 50, less than or equal to about 45, less than or equal to about 40, less than or equal to about 35, less than or equal to about 34, less than or equal to about 33, or less than or equal to about 32.

The fourth semiconductor compound may include, for example, a Group II-VI semiconductor compound, a Group III-V semiconductor compound, a Group IV-VI semiconductor compound, a Group IV semiconductor compound, a Group I-III-VI semiconductor compound, a Group I-II-IV-VI semiconductor compound, a Group II-III-V semiconductor compound, or a combination thereof. Examples of the Group II-VI semiconductor compound, Group III-V semiconductor compound, Group IV-VI semiconductor compound, Group IV semiconductor compound, Group I-III-VI semiconductor compound, Group I-II-IV-VI semiconductor compound, and Group II-III-V semiconductor compound are the same as described above.

For example, the fourth semiconductor compound may include zinc (Zn) and at least one selected from sulfur (S) and selenium (Se). For example, the shell may include ZnSeS, ZnSe, ZnS, or a combination thereof. For example, the shell may include one or more inner shells close to the core and an outermost shell at the outermost of the quantum dot, and at least one of the inner shells and the outermost shell may include a fourth semiconductor compound of ZnS, ZnSe, or ZnSeS.

The quantum dot layer 13 may have a relatively deep HOMO energy level, for example, a HOMO energy level of greater than or equal to about 5.4 eV, for example, a HOMO energy level of greater than or equal to about 5.6 eV, and within the above range, for example, a HOMO energy level of greater than or equal to about 5.7 eV, greater than or equal to about 5.8 eV, greater than or equal to 5.9 eV, or greater than or equal to about 6.0 eV. The quantum dot layer 13 may have, for example, a HOMO energy level about 5.4 eV to about 7.0 eV, for example a HOMO energy level of about 5.4 eV to about 6.8 eV, for example, about 5.4 eV to about 6.7 eV, for example, about 5.4 eV to about 6.5 eV, for example, about 5.4 eV to about 6.3 eV, for example, about 5.4 eV to about 6.2 eV, for example, about 5.4 eV to about 6.1 eV, within the above range, for example a HOMO energy level of about 5.6 eV to about 7.0 eV, for example, about 5.6 eV to about 6.8 eV, for example, about 5.6 eV to about 6.7 eV, for example, about 5.6 eV to about 6.5 eV, for example, about 5.6 eV to about 6.3 eV, for example, about 5.6 eV to about 6.2 eV, for example, about 5.6 eV to about 6.1 eV, within the above range, for example a HOMO energy level of about 5.7 eV to about 7.0 eV, for example, about 5.7 eV to about 6.8 eV, for example, about 5.7 eV to about 6.7 eV, for example, about 5.7 eV to about 6.5 eV, for example, about 5.7 eV to about 6.3 eV, for example, about 5.7 eV to about 6.2 eV, for example, about 5.7 eV to about 6.1 eV, within the above range, for example, a HOMO energy level of about 5.8 eV to about 7.0 eV, for example, about 5.8 eV to about 6.8 eV, for example, about 5.8 eV to about 6.7eV, for example, about 5.8 eV to about 6.5eV, for example, about 5.8 eV to about 6.3 eV, for example, about 5.8 eV to about 6.2 eV, for example, about 5.8 eV to about 6.1 eV, within the above range, for example a HOMO energy level of about 6.0 eV to about 7.0 eV, for example, about 6.0 eV to about 6.8 eV, for example, about 6.0 eV to about 6.7 eV, for example, about 6.0 eV to about 6.5 eV, for example, about 6.0 eV to about 6.3 eV, for example, about 6.0 eV to about 6.2 eV.

The quantum dot layer 13 may have a relatively shallow LUMO energy level, for example, less than or equal to about 3.6 eV, and within this range, for example, less than or equal to about 3.5 eV, for example, less than or equal to about 3.4 eV, for example, less than or equal to about 3.3 eV, for example, less than or equal to about 3.2 eV, or for example, less than or equal to about 3.0 eV. Within the range, the quantum dot layer 13 may have, for example, a LUMO energy level of about 2.5 eV to about 3.6 eV, about 2.5 eV to about 3.5 eV, for example, about 2.5 eV to about 3.4 eV, for example, about 2.5 eV to about 3.3 eV, for example, about 2.5 eV to about 3.2 eV, for example, about 2.5 eV to about 3.1 eV, for example, about 2.5 eV to about 3.0 eV, for example, about 2.8 eV to about 3.6 eV, about 2.8 eV to about 3.5 eV, for example, about 2.8 eV to about 3.4 eV, for example, about 2.8 eV to about 3.3 eV, for example, about 2.8 eV to about 3.2 eV, about 3.0 eV to about 3.6 eV, about 3.0 eV to about 3.5 eV, or for example about 3.0 eV to about 3.4 eV.

The quantum dot layer 13 may be one layer or two or more layers including the same or different quantum dots.

A refractive index of the quantum dot layer 13 in the visible light wavelength region may be about 1.65 to about 2.70, and for example, the refractive indexes of about 460 nm, about 540 nm, and about 630 nm may satisfy the above ranges, respectively. Within the range, the quantum dot layer 13 may have each refractive index in a visible light wavelength region (e.g., about 460 nm, about 540 nm, and about 630 nm) of about 1.70 to about 2.65, about 1.75 to about 2.60, about 1.80 to about 2.55, about 1.80 to about 2.50, about 1.80 to about 2.40, about 1.80 to about 2.30, about 1.80 to about 2.20, about 1.80 to about 2.10, about 1.80 to about 2.00, or about 1.80 to about 1.95.

The quantum dot layer 13 may have a thickness of, for example, about 5 nm to about 200 nm, and within the above range, for example, about 10 nm to about 150 nm, for example, about 10 nm to about 100 nm, for example, about 10 nm to about 80 nm, or for example, about 10 nm to about 50 nm. In the claimed invention, the total thickness of the hole auxiliary layer, the quantum dot layer, and the electron transport layer is as set out in claims 1 and 4.

In the claimed invention, the hole auxiliary layer 14 is disposed between the anode 11 and the quantum dot layer 13, specifically, on the anode 11 and under the quantum dot layer 13. The hole auxiliary layer 14 consists of a hole injection layer 14a and a hole transport layer 14b. The hole injection layer 14a is disposed close to the anode 11 and the hole transport layer 14b is disposed close to the quantum dot layer 13. The hole injection layer 14a may facilitate injection of holes from the anode 11, and the hole transport layer 14b may effectively transfer the injected holes to the quantum dot layer 13. The hole injection layer 14a and the hole transport layer 14b may have one or two or more layers, respectively, and may include an electron blocking layer in a broad sense. In an embodiment not forming part of the claimed invention, any one of the hole injection layer 14a and the hole transport layer 14b may be omitted.

The hole injection layer 14a and the hole transport layer 14b may each have a HOMO energy level between a work function of the anode 11 and a HOMO energy level of the quantum dot layer 13. For example, a work function of the anode 11, a HOMO energy level of the hole injection layer 14a, a HOMO energy level of the hole transport layer 14b, and a HOMO energy level of the quantum dot layer 13 may become deeper, and may be, for example, stepped.

The HOMO energy level of the hole transport layer 14b may have a relatively deep HOMO energy level so as to match the HOMO energy level of the quantum dot layer 13. Accordingly, charge mobility of holes transferred from the hole transport layer 14b to the quantum dot layer 13 may be improved.

The HOMO energy level of the hole transport layer 14b may be equal to or smaller than the HOMO energy level of the quantum dot layer 13 within a range of about 1.0 eV or less. For example, a difference between the HOMO energy levels of the hole transport layer 14b and the quantum dot layer 13 may be about 0 eV to about 1.0 eV, within the above range, for example, about 0.01 eV to about 0.8 eV, within the above range, for example, about 0.01 eV to about 0.7 eV, within the above range, for example, about 0.01 eV to about 0.5 eV, within the above range, for example, about 0.01 eV to about 0.4 eV, for example, about 0.01 eV to about 0.3 eV, for example, about 0.01 eV to about 0.2 eV, for example, about 0.01 eV to about 0.1 eV.

The HOMO energy level of the hole transport layer 14b may be, for example, greater than or equal to about 5.0 eV, within the above range, for example, greater than or equal to about 5.2 eV, within the above range, for example, greater than or equal to about 5.4 eV, within the above range, for example, greater than or equal to about 5.6 eV, within the above range, for example, greater than or equal to about 5.8 eV.

For example, the HOMO energy level of the hole transport layer 14b may be about 5.0 eV to about 7.0 eV, within the above range, for example, about 5.2 eV to about 6.8 eV, within the above range, for example, about 5.4 eV to about 6.8 eV, for example, about 5.4 eV to about 6.7 eV, for example, about 5.4 eV to about 6.5 eV, for example, about 5.4 eV to about 6.3 eV, for example, about 5.4 eV to about 6.2 eV, for example, about 5.4 eV to about 6.1eV, for example, about 5.6 eV to about 7.0 eV, for example, about 5.6 eV to about 6.8 eV, for example, about 5.6 eV to about 6.7 eV, for example, about 5.6 eV to about 6.5 eV, for example, about 5.6 eV to about 6.3 eV, for example, about 5.6 eV to about 6.2 eV, for example, about 5.6 eV to about 6.1 eV, for example, about 5.8 eV to about 7.0 eV, for example, about 5.8 eV to about 6.8 eV, for example, about 5.8 eV to about 6.7 eV, for example, about 5.8 eV to about 6.5 eV, for example, about 5.8 eV to about 6.3 eV, for example, about 5.8 eV to about 6.2 eV, for example, about 5.8 eV to about 6.1 eV.

The refractive index of the hole injection layer 14a and the hole transport layer 14b in the visible light wavelength region may be lower than the refractive index of the quantum dot layer 13 in the visible light wavelength region. For example, a difference between the refractive index of the quantum dot layer 13 and the refractive index of the hole injection layer 14a/hole transport layer 14b may be greater than or equal to about 0.01, and within the above range, about 0.01 to about 1.00, about 0.02 to about 0.80, about 0.03 to about 0.60, about 0.03 to about 0.50, about 0.03 to about 0.40, or about 0.03 to about 0.30.

For example, the refractive indexes of the hole injection layer 14a and the hole transport layer 14b in the visible light wavelength region may be about 1.20 to about 2.5, for example, the refractive indexes of about 460 nm, about 540 nm, and about 630 nm may each satisfy the above ranges. Within the above range, the refractive index in the visible light wavelength region (e.g., about 460 nm, about 540 nm, and about 630 nm) of the electron auxiliary layer 15 may be about 1.20 to about 2.3, about 1.25 to about 2.2, about 1.3 to about 2.1, about 1.4 to about 2.0, about 1.45 to about 1.9, or about 1.50 to about 1.9, respectively.

The hole injection layer 14a and the hole transport layer 14b may include for example an organic material, an inorganic material, an organic-inorganic material, or a combination thereof, and may include for example at least one selected from poly(9,9-dioctyl-fluorene-co-N-(4-butylphenyl)-diphenylamine (TFB), polyarylamine, poly(N-vinylcarbazole, poly(3,4-ethylenedioxythiophene (PEDOT), poly(3,4-ethylenedioxythiophene) polystyrene sulfonate (PEDOT:PSS), polyaniline, polypyrrole, N,N,N',N'-tetrakis (4-methoxyphenyl)-benzidine (TPD), 4-bis[N-(1-naphthyl)-N-phenyl-amino]biphenyl ($\alpha$-NPD), m-MTDATA (4,4',4"-tris[phenyl(m-tolyl)amino]triphenylamine), 4,4',4"-tris(N-carbazolyl)-triphenylamine (TCTA), 1,1-bis[(di-4-tolylamino)phenylcyclohexane (TAPC), p-type metal oxide (e.g., NiO, $WO_3$, $MoO_3$, etc.), a carbon-based material such as graphene oxide, and a combination thereof, but are not limited thereto.

In the claimed invention, the electron auxiliary layer 15 is disposed between the cathode 12 and the quantum dot layer 13, specifically disposed on the quantum dot layer 13 and under the cathode 12. The electron auxiliary layer 15 is an electron transport layer.

The electron auxiliary layer 15 may facilitate injection of electrons from the cathode 12 and may effectively transfer the injected electrons to the quantum dot layer 13.

The LUMO energy level of the electron auxiliary layer 15 may be between, for example, the LUMO energy level of the quantum dot layer 13 and a work function of the cathode 12. For example, the work function of the cathode 12, the LUMO energy level of the electron auxiliary layer 15, and the LUMO energy level of the quantum dot layer 13 may become shallower, and may be, for example, stepped.

The HOMO energy level of the electron auxiliary layer 15 may be, for example, deeper than the HOMO energy level of the quantum dot layer 13. For example, the HOMO energy level of the electron auxiliary layer 15 may be deeper than the HOMO energy level of the quantum dot layer 13 by about 0.2 eV or more, about 0.5 eV or more, about 0.8 eV or more, about 1.0 eV or more, about 1.2 eV or more, or about 1.5 eV, for example, about 0.2 eV to about 3.0 eV, about 0.5 eV to about 3.0 eV, about 0.8 eV to about 3.0 eV, about 1.0 eV to about 3.0 eV, about 1.2 eV to about 3.0 eV, or about 1.5 eV to about 3.0 eV.

As an example, the electron auxiliary layer 15 may have a relatively deep HOMO energy level. The HOMO energy level of the electron auxiliary layer 15 may be, for example, about 5.6 eV to about 8.5 eV, within the above range, about 5.8 eV to about 8.2 eV, about 6.0 eV to about 8.0 eV, about 6.2 eV to about 8.0 eV, about 6.5 eV to about 8.0 eV, about 6.8 eV to about 8.0 eV, about 7.0 eV to about 8.0 eV, about 7.2 eV to about 7.9 eV, or about 7.3 eV to about 7.8 eV.

Since the electron auxiliary layer 15 has such an energy level, electrons may be effectively transferred and holes may be effectively blocked, thereby improving stability of the quantum dot device.

The electron auxiliary layer 15 may include a material that satisfies the aforementioned energy level, for example, inorganic nanoparticles. The inorganic nanoparticles may be, for example, oxide nanoparticles, and may be, for example, metal oxide nanoparticles. As an example, the inorganic nanoparticles may be metal oxide nanoparticles including two or more types of metals. For example, the inorganic nanoparticles may be inorganic semiconductors.

The inorganic nanoparticles may be two-dimensional or three-dimensional nanoparticles having an average particle diameter of less than or equal to about 10 nm, and an average particle diameter of less than or equal to about 8 nm, less than or equal to about 7 nm, less than or equal to about 5 nm, less than or equal to about 4 nm, or less than or equal to about 3.5 nm, within the above range, an average particle diameter of about 1 nm to about 10 nm, about 1 nm to about 9 nm, about 1 nm to about 8 nm, about 1 nm to about 7 nm, about 1 nm to about 5 nm, about 1 nm to about 4 nm, or about 1 nm to about 3.5 nm.

As an example, the inorganic nanoparticles may be metal oxide nanoparticles including alkaline earth metal. For example, the inorganic nanoparticles may be metal oxide nanoparticles including beryllium (Be), magnesium (Mg), calcium (Ca), barium (Ba), strontium (Sr), radium (Ra), or a combination thereof.

The inorganic nanoparticles may be metal oxide nanoparticles including at least one selected from zinc (Zn), cobalt (Co), nickel (Ni), gallium (Ga), zirconium (Zr), tungsten (W), titanium (Ti), tantalum (Ta), tin (Sn), and hafnium (Hf), in addition to alkaline earth metals.

For example, the inorganic nanoparticles may be a metal oxide nanoparticles including an alkaline earth metal and zinc (Zn), wherein the alkaline earth metal may be included in a less amount than zinc, and for example, the alkaline earth metal may be included in an amount of about 0.01 at% to about 30 at% or about 0.01 at% to about 20 at% based on a total number of metal atoms, that is, a total number of alkaline-earth metal and zinc included in the inorganic nanoparticles.

For example, the inorganic nanoparticles may be represented by $Zn_{1-x}Q_xO$, wherein Q is Be, Mg, Ca, Ba, Sr, Re, or a combination thereof, and $0<x<0.5$. For example, Q may include Mg, for example, $0.01 \leqq x \leqq 0.3$ or $0.01 \leqq x \leqq 0.2$.

The electron auxiliary layer 15 may further include an additive. The additive may be included in the form of a mixture with inorganic nanoparticles, and may be included in a small amount to improve electron transport characteristics and/or electron injection characteristics of the electron auxiliary layer 15.

The additive may be selected from, for example, alkali metals, alkali metal compounds, alkali metal salts, or combinations thereof. The alkali metal may include, for example, lithium (Li), sodium (Na), potassium (K), cesium (Cs), rubidium (Rb), francium (Fr), or a combination thereof, the alkali metal compound may be a compound including the alkali metal, and the alkali metal salt may be a metal cation derived from an alkali metal compound. The additive may be, for example, an alkali metal compound and/or an alkali metal salt derived therefrom, wherein the additive may further include an anion such as carbonate ($CO_3^{2-}$), phosphate ($PO_4^{3-}$), vanadate ($VO_4^{3-}$), azide ($N_3^-$), or nitride ($N^{3-}$).

For example, the additive may include lithium (Li), sodium (Na), potassium (K), cesium (Cs), rubidium (Rb), francium (Fr), cesium carbonate ($Cs_2CO_3$), cesium phosphate ($Cs_3PO_4$), cesium vanadate ($Cs_3VO_4$), cesium azide ($CsN_3$), lithium carbonate ($LiCO_3$), lithium nitride ($Li_3N$), sodium carbonate ($Na_2CO_3$), potassium carbonate ($K_2CO_3$), rubidium carbonate ($Rb_2CO_3$), or a combination thereof, but is not limited thereto.

The additive may be included in a less amount than inorganic nanoparticles. For example, the additive may be included in an amount of about 0.1 volume% to 30 volume%, within the above range, of about 0.1 volume% to about 25 volume%, about 0.1 volume% to about 20 volume%, about 0.5 volume% to about 18 volume%, about 1 volume% to about 15 volume%, or about 3 volume% to about 15 volume% based on a total amount of the mixture of the inorganic nanoparticles and the additive.

The refractive index of the electron auxiliary layer 15 in the visible light wavelength region may be lower than the refractive index in the visible light wavelength region of the quantum dot layer 13, for example, a difference between the refractive index of the quantum dot layer 13 and the refractive index of the electron auxiliary layer 15 may be greater than or equal to about 0.20, and within the above range, about 0.20 to about 1.00, about 0.20 to about 0.80, about 0.20 to about 0.60, about 0.20 to about 0.50, about 0.20 to about 0.40, or about 0.20 to about 0.30.

For example, the refractive index of the electron auxiliary layer 15 in the visible light wavelength region may be about 1.40 to about 2.5, and for example, the refractive indexes of about 460 nm, about 540 nm, and about 630 nm may satisfy the above ranges, respectively. Within the above range, the refractive indexes of the electron auxiliary layer 15 at about 460 nm, about 540 nm, and about 630 nm may be about 1.40 to about 2.3, about 1.45 to about 2.2, about 1.5 to about 2.1, about 1.5 to about 2.0, about 1.5 to about 1.9, about 1.5 to about 1.8, about 1.5 to about 1.7, or about 1.5 to about 1.65, respectively.

A thickness of the electron auxiliary layer 15 may be, for example, greater than or equal to about 5 nm and less than about 80 nm, and within the above range, for example, about 5 nm to about 70 nm, for example about 5 nm to about 60 nm, or for example, about 5 nm to about 50 nm. In the claimed invention, the electron auxiliary layer is an electron transport layer and the thickness of the electron transport layer is as set out in claims 1 and 4.

The optical auxiliary layer 16 may be disposed on the cathode 12 to further improve the optical characteristics of light emitted toward the top. The optical auxiliary layer 16 may be, for example, a light-transmitting layer or a semi-transmitting layer. The optical auxiliary layer 16 may include an organic material, an inorganic material and/or an inorganic-organic material. The optical auxiliary layer 16 may be one layer or two or more layers. The optical auxiliary layer 16 may be omitted.

A thickness of the optical auxiliary layer 16 may be about 10 nm to about 200 nm, within the above range, about 20 nm to about 200 nm, about 20 nm to about 150 nm, about 20 nm to about 100 nm, about 20 nm to about 80 nm, about 25 nm to about 200 nm, about 25 nm to about 150 nm, about 25 nm to about 100 nm, about 25 nm to about 80 nm, about 30 nm to about 150 nm, about 30 nm to about 100 nm, about 30 nm to about 80 nm, about 35 nm to about 150 nm, about 35 nm to about 100 nm, about 35 nm to about 80 nm, about 40 nm to about 150 nm, about 40 nm to about 100 nm, or about 40 nm to about 80 nm.

The quantum dot device 10 includes an anode 11 including a reflective layer, a cathode 12 and/or an optical auxiliary layer 16 including a semi-transmitting layer, and a quantum dot layer 13, a hole auxiliary layer 14, and an electron auxiliary layer 15 between the reflective layer and the semi-transmitting layer, and thereby a microcavity structure may be formed.

Due to an isotropic light emission characteristics of quantum dots, unlike conventional light emitter such as organic light emitting materials, the light extraction efficiency of toward the cathode 12 of the quantum dot device 10 may be low. Accordingly, the microcavity structure in the quantum dot device 10 may be different from the microcavity structure in the conventional organic light emitting device.

Specifically, light emitted from the quantum dot layer 13 may be radiated in all directions due to the isotropic light emission characteristic of the quantum dot. Accordingly, a part of the light emitted from the quantum dot layer 13 may move toward the anode 11 and be reflected from the reflective layer of the anode 11, and a part of the light emitted from the quantum dot layer 13 may move toward the cathode 12 and be reflected by the cathode 12 and/or the optical auxiliary layer 16. These reflected lights may be resonated repeatedly between the anode 11 and the cathode 12 to be amplified and modified into light of a predetermined wavelength spectrum, and the modified light may pass through the cathode 12 and be emitted to the outside. That is, in the quantum dot device 10, the modified light emitted through the cathode 12 may be different from the light emitted from the quantum dot layer 13.

The optical properties of the modified light emitted through the cathode 12 (hereinafter referred to as "modified light") may be effectively adjusted by fine control of the microcavity structure.

For example, the characteristics of the modified light may be adjusted by a path through which light emitted from a light emitting point (e.g., a quantum dot) passes, for example, a distance between the quantum dot layer 13 and the reflective layer of the anode 11, a distance between the quantum dot layer 13 and the cathode 12, refractive indexes of each layer, and/or the differences in refractive indexes between adjacent layers.

For example, the characteristics of the modified light may be adjusted by a distance between the quantum dot layer 13 and the reflective layer of the anode 11 and/or the distance between the quantum dot layer 13 and the cathode 12.

As the microcavity is repeated, the number of passes between the quantum dot layer 13 and the reflective layer of the anode 11 is greater than the number of passes between the quantum dot layer 13 and the cathode 12, so that a distance between the quantum dot layer 13 and the reflective layer 11 of the anode may be made to be larger than a distance between the quantum dot layer 13 and the cathode 12, and thus microcavity may be effectively adjusted. At this time, the distance between the quantum dot layer 13 and the reflective layer of the anode 11 may be adjusted by, for example, the thickness of the hole auxiliary layer 14, and the distance between the quantum dot layer 13 and the cathode 12 may be adjusted by, for example, the thickness of the electron auxiliary layer 15. For example, by making the hole auxiliary layer 14 thicker than the electron auxiliary layer 15, characteristics of the modified light may be effectively adjusted.

The thickness of the hole auxiliary layer 14 may be determined according to the emission spectrum of the quantum dot layer 13. For example, the thickness of the hole auxiliary layer 14 may be determined so that the resonant wavelength of the microcavity structure of the quantum dot device 10 may belong to the same wavelength spectrum as the emission spectrum of the quantum dot layer 13.

For example, when the quantum dot layer 13 is configured to emit light of a blue wavelength spectrum, the thickness of the hole auxiliary layer 14 may be set to have a resonant wavelength belonging to the blue wavelength spectrum. For example, when the quantum dot layer 13 is configured to emit light of a green wavelength spectrum, the thickness of the hole auxiliary layer 14 may be set to have a resonant wavelength belonging to the green wavelength spectrum. For example, when the quantum dot layer 30 is configured to emit light of a red wavelength spectrum, the thickness of the hole auxiliary layer 14 may be set to have a resonant wavelength belonging to the red wavelength spectrum. These resonant wavelengths may be one or two or more.

For example, when the quantum dot layer 13 is configured to emit light having a blue wavelength spectrum (for example, $\lambda_{max1}$ = about 430 nm to about 485 nm), the thickness of the hole auxiliary layer 14 may be about 100 nm to about 160 nm. Within the above range, the thickness of the hole auxiliary layer 14 may be about 110 nm to about 150 nm, about 120 nm to about 145 nm, or about 125 nm to about 140 nm. **In** the claimed invention, the thicknes of the hole auxiliary layer is as set out in claim 1.

For example, when the quantum dot layer 13 is configured to emit light of a blue wavelength spectrum (e.g., $\lambda_{max1}$ = about 430 nm to about 485 nm), a total thickness of the hole auxiliary layer 14, the quantum dot layer 13, and the electron auxiliary layer 15 disposed in a path through which light emitted from a light emitting point (e.g., a quantum dot) passes, may be about 160 nm to about 230 nm. Within the above range, the total thickness of the hole auxiliary layer 14, the quantum dot layer 13, and the electron auxiliary layer 15 may be about 165 nm to about 225 nm, about 160 nm to about 220 nm, or about 155 nm to about 215 nm. **In** the claimed invention, the total thicknes of the hole auxiliary layer, the quantum dot layer, and the electron transport layer is as set out in claim 1.

As an example, when the quantum dot layer 13 is configured to emit light in a red wavelength spectrum (for example, $\lambda_{max1}$ = about 600 nm to about 680 nm), the thickness of the hole auxiliary layer 14 may be thicker or thinner than the thickness of the hole auxiliary layer 14 in the case that the quantum dot layer 13 is configured to emit light in the blue wavelength spectrum. For example, the thickness of the hole auxiliary layer 14 when the quantum dot layer 13 is configured to emit light in the red wavelength spectrum may be about 0.1 times to about 0.9 times (first resonance) or about 1.2 times to about 3 times (second resonance) of the thickness of the hole auxiliary layer 14 when the quantum dot layer 13 is configured to emit light in the blue wavelength spectrum.

For example, when the quantum dot layer 13 is configured to emit light of a red wavelength spectrum, the thickness of the hole auxiliary layer 14 may be about 30 nm to about 80 nm (first resonance) or about 230 nm to about 280 nm (second resonance). Within the above range, the thickness of the hole auxiliary layer 14 may be about 35 nm to about 75 nm, about 40 nm to about 70 nm, about 45 nm to about 65 nm, about 235 nm to about 275 nm, about 240 nm to about 270 nm, or about 245 nm to about 265 nm. **In** the claimed invention, the thicknes of the hole auxiliary layer is as set out in claim 4.

For example, when the quantum dot layer 13 is configured to emit light of a red wavelength spectrum (for example, $\lambda_{max1}$ = about 600 nm to about 680 nm), a total thickness of the hole auxiliary layer 14, the quantum dot layer 13, and the electron auxiliary layer 15 disposed in a path through which light emitted from a light emitting point (e.g., a quantum dot) passes may be about 75 nm to about 135 nm or about 270 nm to about 330 nm. Within this range, the total thickness of the hole auxiliary layer 14, the quantum dot layer 13, and the electron auxiliary layer 15 may be about 80 nm to about 130 nm, about 85 nm to about 125 nm, about 90 nm to about 120 nm, about 275 nm to about 325 nm, or about 280 nm to about 320 nm. **In** the claimed invention, the total thicknes of the hole auxiliary layer, the quantum dot layer, and the electron transport layer is as set out in claim 4.

As an example, when the quantum dot layer 13 is configured to emit light in a green wavelength spectrum (e.g., $\lambda_{max1}$ = about 510 nm to about 575 nm), the thickness of the hole auxiliary layer 14 may be thicker or thinner than the thickness of the hole auxiliary layer 14 in the case that the quantum dot layer 13 is configured to emit light in the blue wavelength spectrum or the thickness of the hole auxiliary layer 14 in the case that the quantum dot layer 13 is configured to emit light in the red wavelength spectrum. For example, the thickness of the hole auxiliary layer 14 when the quantum dot layer 13 is configured to emit light in the green wavelength spectrum may be about 0.1 times to about 0.9 times (first resonance) or about 1.2 times to about 3 times (second resonance) of the thickness of the hole auxiliary layer 14 when the quantum dot layer 13 is configured to emit light in the blue wavelength spectrum or the thickness of the hole auxiliary layer 14 when the quantum dot layer 13 is configured to emit light of a red wavelength spectrum.

By adjusting the thickness of the hole auxiliary layer 14 as described above, the light emission spectrum of the modified light may belong to the same wavelength spectrum as the emission spectrum of light emitted from the quantum dot layer 13. For example, the emission spectrum of the light emitted from the quantum dot layer 13 and the emission spectrum of the modified light may belong to one of a blue wavelength spectrum, a green wavelength spectrum, and a red wavelength spectrum in common. For example, the emission peak wavelength of the quantum dot layer 13 and the emission peak wavelength of the modified light may belong to one of a blue wavelength spectrum, a green wavelength spectrum, and a red wavelength spectrum in common.

For example, the emission peak wavelength ($\lambda_{max1}$) of the quantum dot layer 13 and the emission peak wavelength ($\lambda_{max2}$) of the modified light may fall within about 430 nm to about 485 nm, respectively, and may be configured to display blue. Herein, a difference between the emission peak wavelength ($\lambda_{max1}$) of the quantum dot layer 13 and the emission peak wavelength ($\lambda_{max2}$) of the modified light may be about $\pm 10$ nm, about $\pm 8$ nm, about $\pm 7$ nm, about $\pm 5$ nm, about $\pm 4$ nm, about $\pm 3$ nm, or about $\pm 2$ nm.

For example, the emission peak wavelength ($\lambda_{max1}$) of the quantum dot layer 13 and the emission peak wavelength ($\lambda_{max2}$) of the modified light may fall within about 600nm to about 680nm, respectively, and may be configured to display red. Herein, a difference between the emission peak wavelength ($\lambda_{max1}$) of the quantum dot layer 13 and the emission peak wavelength ($\lambda_{max2}$) of the modified light may be about $\pm 10$ nm, about $\pm 8$ nm, about $\pm 7$ nm, about $\pm 5$ nm, about $\pm 4$ nm, about $\pm 3$ nm, or about $\pm 2$ nm.

For example, the emission peak wavelength ($\lambda_{max1}$) of the quantum dot layer 13 and the emission peak wavelength ($\lambda_{max2}$) of the modified light may fall within about 510 nm to about 570 nm, and may be configured to display green. Herein, a difference between the emission peak wavelength ($\lambda_{max1}$) of the quantum dot layer 13 and the emission peak wavelength ($\lambda_{max2}$) of the modified light may be about $\pm 10$ nm, about $\pm 8$ nm, about $\pm 7$ nm, about $\pm 5$ nm, about $\pm 4$ nm, about $\pm 3$ nm, or about $\pm 2$ nm.

On the other hand, a color purity of the modified light may be higher than a color purity of the light emitted from the quantum dot layer 13, for example, a full width at half maximum ($FWHM_2$) of the emission spectrum of the modified light may be narrower than a full width at half maximum ($FWHM_1$) of the emission spectrum of the quantum dot layer 13. For example, the full width at half maximum ($FWHM_2$) of the light emission spectrum of the modified light may be about 0.1 times to about 0.9 times, within the above range, about 0.2 times to about 0.9 times, about 0.2 times to about 0.8 times, about 0.3 times to about 0.8 times, about 0.4 times to about 0.8 times, or about 0.5 times to about 0.8 times of the full width at half maximum ($FWHM_1$) of the emission spectrum of the quantum dot layer 13. For example, a difference between the full width at half maximum ($FWHM_1$) of the emission spectrum of the quantum dot layer 13 and the full width at half maximum ($FWHM_2$) of the emission spectrum of the modified light may be about 2 nm to about 30 nm, about 3 nm to about 30 nm, or about 5 nm to about 30 nm. Here, the full width at half maximum ($FWHM_1$) of the emission spectrum of the quantum dot layer 13 may be confirmed from a quantum dot device that does not use the microcavity structure.

For example, the characteristics of the modified light may be more effectively adjusted by a refractive index of each layer and/or a difference of refractive indexes between adjacent layers. The refractive indexes of the quantum dot layer 13, the hole auxiliary layer 14, and the electron auxiliary layer 15 disposed in the path through which light emitted from the light emitting point (e.g., a quantum dot) passes are the same as described above. The quantum dot layer 13, the hole auxiliary layer 14, and the electron auxiliary layer 15 each have the aforementioned refractive indexes, so that the microcavity structure of the quantum dot device 10 may be effectively adjusted, thereby further improving a quality of light emitted through the cathode 12.

As such, the quantum dot device 10 is a normal structured and top emission typed light emitting device in which the anode 11, the hole auxiliary layer 14, the quantum dot layer 13, the electron auxiliary layer 15, and the cathode 12 are stacked in order on the substrate 110. A display quality of the quantum dot device 10 may be improved by increasing extraction efficiency of light emitted through the cathode 12 and improving color purity.

The quantum dot device 10 may be manufactured by various methods, for example, forming the anode 11 on the substrate 110, forming the hole auxiliary layer 14, forming the quantum dot layer 13, forming the electron auxiliary layer 15, forming the cathode 12, and optionally forming the optical auxiliary layer 16.

The quantum dot layer 13, the hole auxiliary layer 14, and/or the electron auxiliary layer 15 may be formed by a solution process, such as spin coating, slit coating, inkjet printing, nozzle printing, spraying and/or doctor blade coating, but the present disclosure is not limited thereto.

At least one of forming the quantum dot layer 13, forming the hole auxiliary layer 14, and/or forming the electron auxiliary layer 15 may be further performed by selectively drying and/or heat treatment after the solution process. The heat treatment may be performed at, for example, about 50 °C to about 300 °C, within a range of about 1 minute to 10 hours, but the present disclosure is not limited thereto.

The aforementioned quantum dot device may be applied to various electronic devices that require light emission, and may be applied to various electronic devices such as display devices, for example, TVs, monitors, computers, mobile devices, and lighting devices, for example light sources.

Hereinafter, an example of a quantum dot display device including the aforementioned quantum dot device will be described.

The quantum dot display device includes a quantum dot display panel and a driver, and the quantum dot display panel includes a quantum dot device array in which a plurality of quantum dot devices as above-mentioned are arranged.

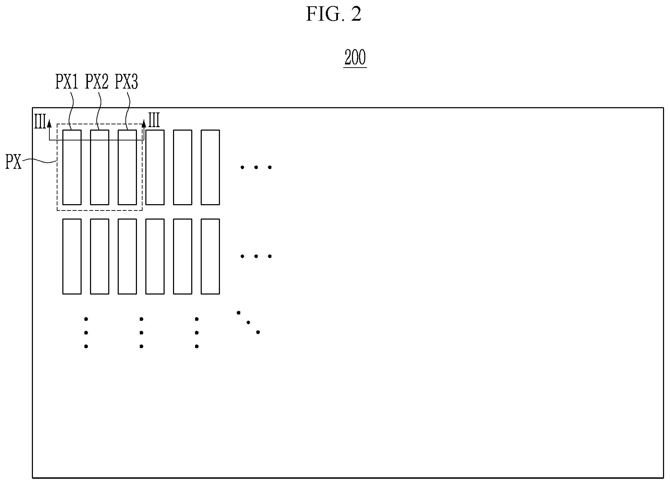

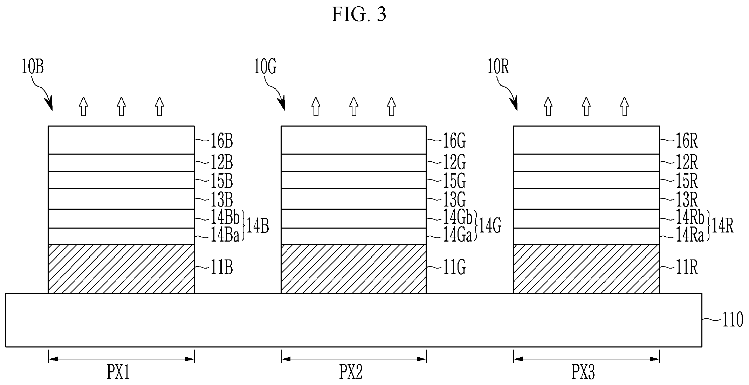

FIG. 2 is a schematic view showing an example of a quantum dot display panel of a quantum dot display device according to an embodiment, and FIG. 3 is a cross-sectional view of the quantum dot display panel of FIG. 2 taken along line III-III.

Referring to FIG. 2, a quantum dot display panel 200 includes a plurality of pixels PX, and the plurality of pixels PX are repeatedly aligned along a row and/or a column to form a quantum dot device array. Each pixel PX may be one unit element and includes a plurality of sub-pixels PX1, PX2, and PX3 configured to display different colors. In FIG. 2, the pixel PX consisting of the plurality of sub-pixels PX1, PX2, and PX3 configured to display different colors is shown as an example, but is not limited thereto, and each pixel PX may include two or more at least one of the sub-pixels PX1, PX2, and PX3 or each pixel PX may further include an additional sub-pixel such as a white sub-pixel (not shown). The sub-pixels PX1, PX2, and PX3 in each pixel PX may be aligned, for example, into a Bayer matrix, a PenTile matrix, a diamond matrix, and/or the like, but is not limited thereto.

In the drawing, all the pixels PX are shown to have the same size but not limited thereto, and at least one pixel PX may be larger or smaller than the other pixels PX. In the drawing, all the pixels PX are shown to have the same shape but not limited thereto, and at least one pixel PX may have a different shape from those of the other pixels PX.

In the drawing, all the sub-pixels PX1, PX2, and PX3 are shown to have the same size but not limited thereto, and at least one sub-pixel PX1, PX2, or PX3 may be larger or smaller than the sub-pixels PX1, PX2, or PX3. In the drawing, all the sub-pixels PX1, PX2, and PX3 are shown to have the same shape but not limited thereto, and at least one sub-pixel PX1, PX2, or PX3 may have a different shape from those of the other sub-pixels PX1, PX2, or PX3.

Referring to FIG. 3, the quantum dot display panel 200 includes a blue quantum dot device 10B configured to display blue, a green quantum dot device 10G configured to display green, and a red quantum dot device 10R configured to display red, on the substrate 110.

Each of the blue quantum dot device 10B, the green quantum dot device 10G, and the red quantum dot device 10R may be the aforementioned quantum dot device 10.

Specifically, the blue quantum dot device 10B includes an anode 11B including a reflective layer; a cathode 12B; a quantum dot layer 13B between the anode 11B and the cathode 12B; a hole auxiliary layer 14B between the anode 11B and the quantum dot layer 13B and including a hole injection layer 14Ba and a hole transport layer 14Bb; an electron auxiliary layer 15B between the cathode 12B and the quantum dot layer 13B; and optionally an optical auxiliary layer 16B.

The quantum dot layer 13B may include cadmium-free quantum dots configured to emit light of a blue wavelength spectrum, and may have an emission spectrum having an emission peak wavelength ($\lambda_{max1}$) belonging to about 430 nm to about 485 nm. For example, the quantum dot layer 13B may include a core-shell quantum dot, and the core-shell quantum dot may include, for example, a semiconductor compound including zinc (Zn) and at leasat one of tellurium (Te) and selenium (Se), for example, a core including a Zn-Te-Se-based semiconductor compound including zinc (Zn), tellurium (Te), and selenium (Se), and at least one shell including ZnSeS, ZnSe, and/or ZnS.

A refractive index of the quantum dot layer 13B in a blue wavelength region (e.g., about 460 nm) may be about 1.65 to about 2.70, about 1.70 to about 2.65, about 1.75 to about 2.60, about 1.80 to about 2.55, about 1.80 to about 2.50, about 1.80 to about 2.40, about 1.80 to about 2.30, about 1.80 to about 2.20, about 1.80 to about 2.10, about 1.80 to about 2.00, or about 1.80 to about 1.95.

The hole auxiliary layer 14B may serve to adjust a distance between the quantum dot layer 13B and the reflective layer of the anode 11B in of the blue quantum dot device 10B. As described above, the thickness of the hole auxiliary layer 14B may be determined so that a resonant wavelength of the microcavity structure of the blue quantum dot device 10B belongs to the same wavelength spectrum as the emission spectrum of the quantum dot layer 13B, that is, a blue wavelength spectrum. Accordingly, the thickness of the hole auxiliary layer 14B may be about 100 nm to about 160 nm, and within the above range, the thickness of the hole auxiliary layer 14B may be about 110 nm to about 150 nm, about 120 nm to about 145 nm, or about 125 nm to about 140 nm.

For example, a total thickness of the hole auxiliary layer 14B, the quantum dot layer 13B, and the electron auxiliary layer 15B disposed in the path through which light emitted from the light emitting point (e.g., a quantum dot) passes may be about 160 nm to about 230 nm, within the above range, about 165 nm to about 225 nm, about 160 nm to about 220 nm, or about 160 nm to about 215 nm.

The green quantum dot device 10G includes an anode 11G including a reflective layer; a cathode 12G; a quantum dot layer 13G between the anode 11G and the cathode 12G; a hole auxiliary layer 14G between the anode 11G and the quantum dot layer 13G and including a hole injection layer 14Ga and a hole transport layer 14Gb; a electron auxiliary layer 15G between the cathode 12G and the quantum dot layer 13G; optionally an optical auxiliary layer 16G.

The quantum dot layer 13G may include cadmium-free quantum dots configured to emit light of a green wavelength spectrum, and may have an emission spectrum having an emission peak wavelength ($\lambda_{max1}$) belonging to about 510 nm to about 570 nm.

The hole auxiliary layer 14G may serve to adjust a distance between the quantum dot layer 13G and the reflective layer of the anode 11G in of the green quantum dot device 10G. As described above, the thickness of the hole auxiliary layer 14G may be determined so that a resonant wavelength of the microcavity structure of the green quantum dot device 10G belongs to the same wavelength spectrum as the emission spectrum of the quantum dot layer 13G, that is, a green wavelength spectrum. A thickness of the hole auxiliary layer 14G may be different from a thickness of the hole auxiliary layer 14B. For example, a total thickness of the hole auxiliary layer 14G, the quantum dot layer 13G, and the electron auxiliary layer 15G of the green quantum dot device 10G which are disposed in the path through which light emitted from the light emitting point (e.g., a quantum dot) passes may be different from a total thickness of the hole auxiliary layer 14B, the quantum dot layer 13B, and the electron auxiliary layer 15B of the blue quantum dot device 10B.

The red quantum dot device 10R includes an anode 11R including a reflective layer; a cathode 12R; a quantum dot layer 13R between the anode 11R and the cathode 12R; a hole auxiliary layer 14R between the anode 11R and the quantum dot layer 13R and including a hole injection layer 14Ra and a hole transport layer 14Rb; an electron auxiliary layer 15R between the cathode 12R and the quantum dot layer 13R; and optionally an optical auxiliary layer 16R.

The quantum dot layer 13R may include cadmium-free quantum dots configured to emit light of a red wavelength spectrum, and may have an emission spectrum having an emission peak wavelength ($\lambda_{max1}$) belonging to about 600 nm to about 680 nm. For example, the quantum dot layer 13R may include a core-shell quantum dot, and the core-shell quantum dot may include, for example, a core including a semiconductor compound including indium (In), phosphorus (P), and optionally zinc (Zn), and at least one shell including ZnSeS, ZnSe, and/or ZnS.

A refractive index of the quantum dot layer 13R in a red wavelength region (e.g., about 630 nm) may be about 1.65 to about 2.70, about 1.70 to about 2.65, about 1.75 to about 2.60, about 1.80 to about 2.55, about 1.80 to about 2.50, about 1.80 to about 2.40, about 1.80 to about 2.30, about 1.80 to about 2.20, about 1.80 to about 2.10, about 1.80 to about 2.00, or about 1.80 to about 1.95.

The hole auxiliary layer 14R may serve to adjust a distance between the quantum dot layer 13R and the reflective layer of the anode 11R in of the red quantum dot device 10R. As described above, the thickness of the hole auxiliary layer 14R may be determined so that a resonant wavelength of the microcavity structure of the red quantum dot device 10R belongs to the same wavelength spectrum as the emission spectrum of the quantum dot layer 13R, that is, a red wavelength spectrum. Accordingly, the thickness of the hole auxiliary layer 14R of the red quantum dot device 10R may be thinner or thicker than the thickness of the hole auxiliary layer 14B of the blue quantum dot device 10B, and the thickness of the hole auxiliary layer 14R of the red quantum dot device 10R may be about 0.1 times to about 0.9 times (first resonance) or about 1.2 times to about 3 times (second resonance) of the hole auxiliary layer 14B of the blue quantum dot device 10B. For example, the thickness of the hole auxiliary layer 14R of the red quantum dot device 10R may be about 30 nm to about 80 nm (first resonance) or about 230 nm to about 280 nm (second resonance), and within the above range, the thickness of the hole auxiliary layer 14R of the red quantum dot device 10R may be about 35 nm to about 75 nm, about 40 nm to about 70 nm, or about 45 nm to about 65 nm (first resonance), or about 235 nm to about 275 nm, about 240 nm to about 270 nm, or about 245 nm to about 265 nm (second resonance). In the claimed invention, the thickness of the hole auxiliary layer is as set out in claim 4.

For example, a total thickness of the hole auxiliary layer 14R, the quantum dot layer 13R, and the electron auxiliary layer 15R disposed in the path through which light emitted from the light emitting point (e.g., a quantum dot) passes may be about 75 nm to about 135nm (first resonance) or about 270 nm to about 330 nm (second resonance), within the above range, about 80 nm to about 130 nm, about 85 nm to about 125 nm, about 90 nm to about 120 nm (first resonance), or about 275 nm to about 325 nm or about 280 nm to about 320 nm (second resonance). In the clained invention, the total thickness of the hole auxiliary layer, the quantum dot layer, and the electron transport layer is as set out in claim 4.

A thickness of the electron auxiliary layer 15B of the blue quantum dot device 10B, a thickness of the electron auxiliary layer 15G of the green quantum dot device 10G, and a thickness of the electron auxiliary layer 15R of the red quantum dot device 10R may be the same or different, and for example they may be the same.

A thickness of the quantum dot layer 13B of the blue quantum dot device 10B, a thickness of the quantum dot layer 13G of the green quantum dot device 10G, and a thickness of the quantum dot layer 13R of the red quantum dot device 10R may be the same or different, and for example, they may be the same.

A thickness of the optical auxiliary layer 16B of the blue quantum dot device 10B, a thickness of the optical auxiliary layer 16G of the green quantum dot device 10G, and a thickness of the optical auxiliary layer 16R of the red quantum dot device 10R may be the same or different, and for example, they may be the same.

The blue quantum dot device 10B may be configured to emit light of a blue wavelength spectrum through the cathode 12B and may be configured to display blue. Herein, the color displayed by the blue quantum dot device 10B may be color of modified light of light in the blue wavelength spectrum emitted from the quantum dot layer 13B, and may be blue having a high purity with a narrower full width at half maximum (FWHM) than that of the blue wavelength spectrum emitted from the quantum dot layer 13B. For example, the full width at half maximum ($FWHM_2$) of the blue emission spectrum displayed by the blue quantum dot device 10B may be about 0.1 times to about 0.9 times, within the above range, about 0.2 times to about 0.9 times, about 0.2 times to about 0.8 times, about 0.3 times to about 0.8 times, about 0.4 times to about 0.8 times, or about 0.5 times to about 0.8 times of the full width at half maximum ($FWHM_1$) of the emission spectrum of the quantum dot layer 13B. For example, the full width at half maximum ($FWHM_2$) of the blue emission spectrum displayed by the blue quantum dot device 10B may be about 2 nm to about 30 nm, about 3 nm to about 30 nm, or about 5 nm to about 30 nm.

The green quantum dot device 10G may be configured to emit light of a green wavelength spectrum through the cathode 12G and may be configured to display green. Herein, the color displayed by the green quantum dot device 10G may be color of modified light of light in the green wavelength spectrum emitted from the quantum dot layer 13G, and may be green having high purity with a narrower full width at half maximum (FWHM) than the light of the green wavelength spectrum emitted from the quantum dot layer 13G. For example, the full width at half maximum ($FWHM_2$) of the green emission spectrum of the green quantum dot device 10G may be about 0.1 times to about 0.9 times, within the above range, about 0.2 times to about 0.9 times, about 0.2 times to about 0.8 times, about 0.3 times to about 0.8 times, about 0.4 times to about 0.8 times, or about 0.5 times to about 0.8 times of the full width at half maximum ($FWHM_1$) of the quantum dot layer 13G. For example, the full width at half maximum ($FWHM_2$) of the green emission spectrum displayed by the green quantum dot device 10G may be about 2 nm to about 30 nm, about 3 nm to about 30 nm, or about 5 nm to about 30 nm.

The red quantum dot device 10R may be configured to emit light of a red wavelength spectrum through the cathode 12R and may be configured to display red. Herein, the color displayed by the red quantum dot device 10R may be color of modified light of light in the red wavelength spectrum emitted from the quantum dot layer 13R and may be red having a high purity with a narrower full width at half maximum (FWHM) than that of the red wavelength spectrum emitted from the quantum dot layer 13R. For example, the full width at half maximum ($FWHM_2$) of the red emission spectrum displayed by the red quantum dot device 10R may be about 0.1 times to about 0.9 times, within the above range, about 0.2 times to about 0.9 times, about 0.2 times to about 0.8 times, about 0.3 times to about 0.8 times, about 0.4 times to about 0.8 times, or about 0.5 times to about 0.8 times of the full width at half maximum ($FWHM_1$) of the emission spectrum of the quantum dot layer 13R. For example, the full width at half maximum ($FWHM_2$) of the red emission spectrum displayed by the red quantum dot device 10R may be about 2 nm to about 35 nm, about 3 nm to about 35 nm, or about 5 nm to about 35 nm.

The quantum dot display panel 200 may be configured to display full colors by combining a blue quantum dot device 10B, a green quantum dot device 10G, and a red quantum dot device 10R.

Hereinafter, the embodiments are illustrated in more detail with reference to examples. However, these examples are exemplary, and the present scope is not limited thereto.

Calculation of Light Extraction Efficiency

In a quantum dot device (a blue quantum dot device or a red quantum dot device) shown in FIG. 1, a thickness of each layer, which may optimize light extraction efficiency, is evaluated.

A Fresnel constant on the interface of each layer is calculated using a refractive index (n) of each layer constituting the device, and then, the thickness of each layer that satisfies thin film interference and wide angle interference is calculated using the Fresnel constant.

The refractive index is measured by using an Ellipsometry equipment (J.A.Woollam Co., Inc.) from a change in polarization properties (Delta, Psi).

Table 1

|  | n (@460 nm) | n (@630 nm) |
|---|---|---|
| First layer (hole injection layer) | 1.56 | 1.54 |
| Second layer (hole transport layer) | 1.89 | 1.73 |
| Third layer (light emitting point, quantum dot layer) | 1.94 | 1.89 |
| Fourth layer (electron auxiliary layer) | 1.62 | 1.60 |

$$\text{Fresnel constant} = [(n_2 - n_1)/(n_2 + n_1)]^2$$

($n_1$ is a refractive index of the material of the first layer and $n_2$ is a refractive index of the material of the second layer)

- Thin Film Interference:

(a)

$$\text{Optical density} = 2nd = m\lambda$$

(n: a refractive index, d: a distance between anode and cathode, m: resonance order, and $\lambda$: a target wavelength)

- Wide Angle Interference:

(b)

$$\text{Optical density} = 2nx = \{(m-1) + 1/2\} * \lambda$$

(n: a refractive index, x: a distance between the light emitting point and the reflective layer, m: a resonance order, and $\lambda$: a target wavelength)

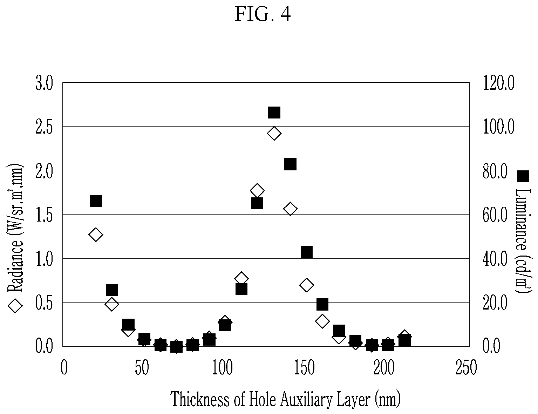

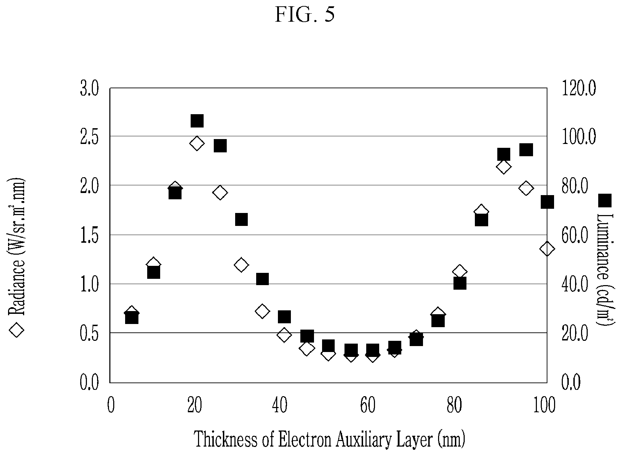

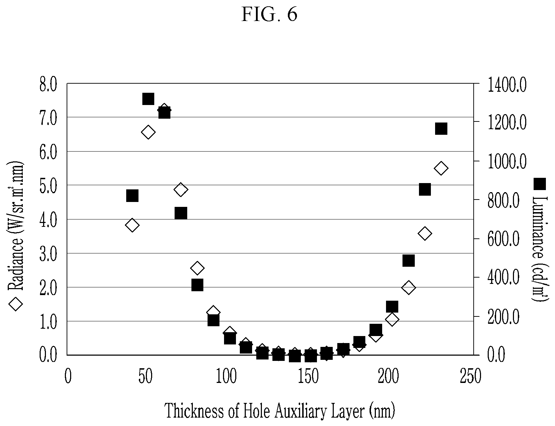

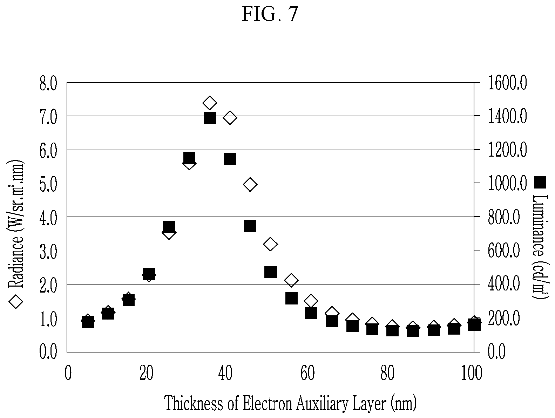

FIG. 4 is a graph showing changes in radiance and luminance according to the thickness of a hole auxiliary layer of a blue quantum dot device, FIG. 5 is a graph showing changes in radiance and luminance according to the thickness of an electron auxiliary layer of a blue quantum dot device, FIG. 6 is a graph showing changes in radiance and luminance according to the thickness of a hole auxiliary layer of a red quantum dot device, and FIG. 7 is a graph showing changes in radiance and luminance according to the thickness of an electron auxiliary layer of a red quantum dot device.

In FIG. 4, in the blue quantum dot device with a microcavity structure, when the thicknesses of the electron auxiliary layer and the optical auxiliary layer are fixed (e.g., 20 nm and 50 nm, respectively), light extraction efficiency depending on the thickness of the hole auxiliary layer may be examined.

In FIG. 5, in the blue quantum dot device with a microcavity structure, when the thicknesses of the hole auxiliary layer and the optical auxiliary layer are fixed (e.g., 140 nm and 50 nm, respectively), light extraction efficiency depending on the thickness of the electron auxiliary layer may be examined.

Referring to FIGS. 4 and 5, in the blue quantum dot device with a microcavity structure, light emitting characteristics are changed depending on the thicknesses of the hole auxiliary layer and the electron auxiliary layer, and accordingly, the thicknesses of the hole auxiliary layer and the electron auxiliary layer may be designed to optimize light extraction efficiency.

In FIG. 6, in the red quantum dot device with a microcavity structure, when the thicknesses of the electron auxiliary layer and the optical auxiliary layer are fixed (e.g., 30 nm and 80 nm, respectively), light extraction efficiency depending on the thickness of the hole auxiliary layer may be examined.

In FIG. 7, in the red quantum dot device with a microcavity structure, when the thicknesses of the hole auxiliary layer and the optical auxiliary layer are fixed (e.g., 55 nm and 80 nm, respectively), light extraction efficiency depending on the thickness of the electron auxiliary layer may be examined.

Referring to FIGS. 6 and 7, in red quantum dot device with the microcavity structure, light emitting characteristics are changed depending on the thicknesses of the hole auxiliary layer and the electron auxiliary layer, and accordingly, the thicknesses of the hole auxiliary layer and the electron auxiliary layer may be designed so as to optimize light extraction efficiency.

Synthesis of Quantum Dots

Synthesis Example 1: Synthesis 1 of Blue Quantum Dot

(1) Synthesis of ZnTeSe Core Quantum Dot Dispersion

Selenium (Se) and tellurium (Te) are respectively dispersed in trioctylphosphine (TOP) to obtain a Se/TOP stock solution and a Te/TOP stock solution. In a reactor containing trioctylamine, 0.125 mmol of zinc acetate is added thereto along with oleic acid and then, heated at 120 °C under vacuum. After 1 hour, an atmosphere in the reactor is converted into nitrogen. After heating the reactor at 300 °C, the prepared Se/TOP stock solution and Te/TOP stock solution in a Te/Se ratio of 1/25 are rapidly injected thereinto. When a reaction is complete, the reaction solution is rapidly cooled down to room temperature, and acetone is added thereto and then, centrifuged to obtain precipitates, and the precipitates are dispersed in toluene to obtain ZnTeSe quantum dot dispersion.

(2) Synthesis of ZnTeSe Core/ZnSeS Shell Quantum Dot Dispersion

1.8 mmol (0.336 g) of zinc acetate along with oleic acid is put in a flask containing trioctylamine and then, vacuum-treated at 120 °C for 10 minutes. The flask is internally substituted with nitrogen ($N_2$) and then, heated up to 180 °C. Subsequently, the obtained ZnTeSe quantum dot dispersion is added thereto, and Se/TOP and S/TOP are injected thereinto. The reaction temperature is set at 280 °C or so. When the reaction is all complete, the reactor is cooled down, and the obtained nanocrystals are centrifuged with ethanol and then, dispersed in toluene to obtain ZnTeSe core/ZnSeS shell quantum dot dispersion.

Synthesis Example 2: Synthesis 2 of Blue Quantum Dot

Zinc chloride is dissolved in ethanol to obtain a zinc chloride solution at a concentration of 10wt%. 0.01 mL of the zinc chloride solution is added to the ZnTeSe core/ZnSeS shell quantum dot dispersion according to Synthesis Example 1 and then, stirred at 60 °C for 30 minutes to perform a surface exchange reaction. After the reaction, ethanol is added thereto to induce precipitates and then, centrifuged, this process is several times repeated to obtain the precipitates, and the precipitates are dispersed in cyclohexane to obtain halogen-treated ZnTeSe core/ZnSeS shell quantum dot dispersion.

Synthesis Example 3: Synthesis of Red Light Emitting Quantum Dot

(1) Synthesis of InP Core Quantum Dot Dispersion

0.2 mmol of indium acetate along with palmitic acid is dissolved in 1-octadecene in a 300 mL reaction flask and then, heated at 120 °C under vacuum. After 1 hour, the atmosphere in the reactor is converted into nitrogen. Subsequently, after heating the reactor at 280 °C, a solution of a tris(trimethylsilyl)phosphine (TMS3P) in trioctylphosphine is rapidly injected thereinto and then, reacted for 30 minutes. The reaction solution is rapidly cooled down to room temperature, and acetone is added thereto and then centrifuged to obtain precipitates, and the precipitates are dispersed in toluene to obtain InP quantum dot dispersion.

(2) Synthesis of InP Core/ZnSeS Shell Quantum Dot Dispersion

Se powder and S powder are respectively dissolved in TOP to prepare a Se/TOP stock solution and a S/TOP stock solution. In a 300 mL reaction flask, zinc acetate and oleic acid are dissolved in trioctylamine and then, vacuum-treated at 120 °C for 10 minutes. The flask is internally substituted with nitrogen ($N_2$) and then, heated up to 180 °C. The obtained InP quantum dot dispersion is added thereto, and a predetermined amount of the Se/TOP stock solution and a predetermined amount of the S/TOP stock solution are added thereto and then, heated at 280 °C and reacted for 60 minutes. An excessive amount of ethanol is added to the reactant and then, centrifuged. After the centrifugation, a supernatant is poured away, and then, precipitates therefrom are dried and dispersed in chloroform or toluene to obtain InP core/ZnSeS shell quantum dot dispersion.

Synthesis of Inorganic Nanoparticles

Synthesis Example 4

0.93 mmol of magnesium acetate tetrahydrate, 8.07 mmol of zinc acetate dihydrate, and 90 mL of dimethylsulfoxide are put in a reactor and heated at 60 °C in the air. Subsequently, 15 mmol of tetramethylammonium hydroxide pentahydrate is dissolved in 30 mL of ethanol, and 3 mL of the solution per minute is added in a dropwise fashion to the reactor. After stirred for 1 hour, the obtained $Zn_{0.85}Mg_{0.15}O$ nanoparticles and ethyl acetate in a volume ratio of 1:9 are centrifuged and then, dispersed in ethanol to obtain $Zn_{0.85}Mg_{0.15}O$ nanoparticle dispersion.

Synthesis Example 5

0.06 mg of $Cs_2CO_3$ is added to 6 ml of ethanol and then, stirred with a magnetic bar overnight (6 hours or longer) to prepare a $Cs_2CO_3$ solution. Subsequently, the $Zn_{0.85}Mg_{0.15}O$ nanoparticle dispersion according to Synthesis Example 4 and a $Cs_2CO_3$ solution are mixed in a volume ratio of 5:1 to prepare Cs-$Zn_{0.85}Mg_{0.15}O$ nanoparticle dispersion.

# EP 3 920 251 B1

Manufacture of Quantum Dot Device

Example 1

ITO 10 nm, silver (Ag) 1000 nm, and ITO 10 nm are sequentially deposited on a glass substrate to form an anode having an ITO/Ag/ITO electrode structure. The anode is then surface treated using UV-ozone. Subsequently, a PEDOT:PSS solution is spin-coated on the anode and heat-treated at 150 °C for 30 minutes under a nitrogen atmosphere to form a 30 nm-thick hole injection layer (refractive index (n) = 1.56@460 nm). Then, on the hole injection layer, a polymer solution including Polymer A is spin-coated and then, heat-treated at 150 °C for 30 minutes to form a 95 nm-thick hole transport layer (n = 1.68@460 nm). Herein, Polymer A includes an alkyl-substituted fluorene structural unit and a triphenylamine structural unit substituted with a phenyl-substituted carbazolyl group. Subsequently, on the hole transport layer, the halogen-treated ZnTeSe core/ZnSeS shell quantum dot dispersion obtained from Synthesis Example 2 is coated and then, cured at 80 °C for 30 minutes under a nitrogen atmosphere to form a 20 nm-thick lower quantum dot layer (a refractive index (n) = 2.18@460 nm, $\lambda_{max}$ = 453 nm), and on the lower quantum dot layer, and the halogen-treated ZnTeSe core/ZnSeS shell quantum dot dispersion obtained from Synthesis Example 2 is coated and then, cured under the same condition as above to form a 20 nm-thick upper quantum dot layer (a refractive index (n) = 2.18@460 nm, $\lambda_{max}$ = 453 nm). On the upper quantum dot layer, the $Zn_{0.85}Mg_{0.15}O$ nanoparticle dispersion obtained from Synthesis Example 4 is spin-coated and then heat-treated at 140 °C for 30 minutes to form a 20 nm-thick electron transport layer (n = 1.62@460 nm). On the electron transport layer, magnesium-silver (MgAg) (90:10 w/w) are deposited to form a 12 nm-thick cathode. Then, an arylamine compound is deposited on the cathode to form a 50 nm-thick optical auxiliary layer to manufacture a blue light emitting quantum dot device with a top emission typed structure.

Example 2

A blue light emitting quantum dot device with a top emission typed structure is manufactured according to the same method as Example 1 except that lower and upper quantum dot layers ($\lambda_{max}$ = 462 nm) are formed instead of the lower and upper quantum dot layers ($\lambda_{max}$ = 453 nm), and a 105 nm-thick hole transport layer is formed instead of the 95 nm-thick hole transport layer.

Example 3

A blue light emitting quantum dot device with a top emission typed structure is manufactured according to the same method as Example 1 except that a 105 nm-thick hole transport layer is formed instead of the 95 nm-thick hole transport layer, and the $Cs-Zn_{0.85}Mg_{0.15}O$ nanoparticle dispersion obtained from Synthesis Example 5 is used instead of the $Zn_{0.85}Mg_{0.15}O$ nanoparticle dispersion obtained from Synthesis Example 4.

Example 4

A blue light emitting quantum dot device with a top emission typed structure is manufactured according to the same method as Example 1 except that a poly[(9,9-dioctylfluorenyl-2,7-diyl-co(4,4'-(N-4-butylphenyl)diphenylamine] (TFB) solution instead of Polymer A is spin-coated and heat-treated at 150 °C for 30 minutes to form a 100 nm-thick hole transport layer (n = 1.89@460 nm).

Example 5

ITO 10 nm, silver (Ag) 1000 nm, and ITO 10 nm are sequentially deposited on a glass substrate to form an anode having an ITO/Ag/ITO electrode structure. The anode is then surface treated using UV-ozone. Subsequently, a PEDOT:PSS solution is spin-coated on the anode and heat-treated at 150 °C for 30 minutes under a nitrogen atmosphere to form a 30 nm-thick hole injection layer (n = 1.56@460 nm). On the hole injection layer, a poly[(9,9-dioctylfluorenyl-2,7-diyl-co(4,4'-(N-4-butylphenyl)diphenylamine] (TFB) solution is spin-coated and then heat-treated it at 150 °C for 30 minutes to form a 110 nm-thick hole transport layer (n = 1.89@460 nm). On the hole transport layer, the blue quantum dot dispersion obtained from Synthesis Example 1 is spin-coated and then cured it at 80 °C for 30 minutes under a nitrogen atmosphere to form a 28 nm-thick quantum dot layer (a refractive index (n) = 2.18@460 nm, $\lambda_{max}$ = 453 nm). Subsequently, on the quantum dot layer, the $Zn_{0.85}Mg_{0.15}O$ nanoparticle dispersion obtained from Synthesis Example 4 is spin-coated and then heat-treated at 140 °C for 30 minutes to form a 20 nm-thick electron transport layer (n = 1.62@460 nm, $\lambda_{max}$ = 453 nm). On the electron transport layer, magnesium-silver (MgAg) (90:10 w/w) are deposited to form a 13 nm-thick cathode. Then, an arylamine compound is deposited on the cathode to form a 50 nm-thick optical auxiliary layer to manufacture a blue light emitting quantum dot device with a top emission typed structure.

Example 6

A blue light emitting quantum dot device with a top emission typed structure is manufactured according to the same method as Example 5 except that a quantum dot layer ($\lambda_{max}$ = 462 nm) is formed instead of the quantum dot layer ($\lambda_{max}$ = 453 nm), and a 30 nm-thick electron transport layer is formed instead of the 20 nm-thick electron transport layer.

Comparative Example 1

A blue light emitting quantum dot device with a top emission typed structure is manufactured according to the same method as Example 5 except that a 25 nm-thick hole transport layer is formed.

Comparative Example 2

A blue light emitting quantum dot device with a top emission typed structure is manufactured according to the same method as Example 3 except that lower and upper quantum dot layer ($\lambda_{max}$ = 462 nm) are formed instead of the lower and upper quantum dot layers ($\lambda_{max}$ = 453 nm), and a 20 nm-thick hole injection layer and a 20 nm-thick hole transport layer are formed.

Comparative Example 3

A blue light emitting quantum dot device with a bottom emission typed structure is manufactured according to the same method as Example 5 except that **ITO** instead of ITO/Ag/ITO is used to form a 150 nm-thick **ITO** anode (transparent anode), aluminum instead of the magnesium-silver is used to form a 120 nm-thick cathode (reflective cathode), and a 25 nm-thick hole transport layer is formed.

Evaluation I

Characteristics of the blue light emitting quantum dot devices according to Examples 1 to 6 and Comparative Examples 1 to 3 are evaluated.
The characteristics of the quantum dot devices are measured by using a current-voltage-luminance measurement equipment (Keithley 2200, Minolta CS200).
The results are shown in Table 2.

Table 2

|  | EQE$_{max}$ (%) | $\lambda_{max}$ (nm) | **FWHM** (nm) | CIE$_x$ | CIE$_y$ |
|---|---|---|---|---|---|
| Example 1 | 28.2 | 450 | 14 | 0.1530 | 0.0230 |
| Example 2 | 19.4 | 461 | 19 | 0.1361 | 0.0499 |
| Example 3 | 34.9 | 457 | 17 | 0.1420 | 0.0400 |
| Example 4 | 23.6 | 452 | 14 | 0.1520 | 0.0240 |
| Example 5 | 17.8 | 450 | 16 | 0.1530 | 0.0230 |
| Example 6 | 19.6 | 462 | 20 | 0.1420 | 0.038 |
| Comparative Example 1 | 1.7 | 455 | 32 | 0.1830 | 0.1770 |
| Comparative Example 2 | 10.1 | 466 | 41 | 0.1280 | 0.1543 |
| Comparative Example 3 | 6.2 | 453 | 24 | 0.1508 | 0.0856 |
| * EQE$_{max}$: maximum external quantum efficiency<br>* $\lambda_{max}$: maximum emission wavelength<br>* FWHM: full width at half maximum | | | | | |

Referring to Table 2, the blue quantum dot devices according to Example 1 to 6 exhibit high efficiency and a narrow full width at half maximum (FWHM), compared with the blue quantum dot devices according to Comparative Examples 1 to 3.

Manufacture of Quantum Dot Device II

Example 7

On a glass substrate, ITO 10 nm, silver (Ag) 1000 nm, and ITO 10 nm are sequentially deposited to form an anode with ITO/Ag/ITO electrode structure. The anode is surface- treated using an UV-ozone. Subsequently, on the anode, a PEDOT:PSS solution is spin-coated and then, heat-treated under a nitrogen atmosphere at 150 °C for 30 minutes to form a 30 nm-thick hole injection layer (n = 1.54@630 nm). On the hole injection layer, a poly[(9,9-dioctylfluorenyl-2,7-diyl-co(4,4'-(N-4-butylphenyl)diphenylamine)] (TFB) solution (n = 1.73@630 nm) is spin-coated and then, heat-treated at 150 °C for 30 minutes to form a 25 nm-thick hole transport layer. Subsequently, on the hole transport layer, the red light emitting quantum dot dispersion obtained from Synthesis Example 3 is spin-coated and then, cured under a nitrogen atmosphere at 120 °C for 30 minutes to form a 20 nm-thick quantum dot layer (n = 1.89@630 nm). On the quantum dot layer, the $Zn_{0.85}Mg_{0.15}O$ nanoparticle dispersion obtained from Synthesis Example 4 is spin-coated and heat-treated at 140 °C for 30 minutes to form a 30 nm-thick electron transport layer (n = 1.60@630 nm). Subsequently, on the electron transport layer, magnesium-silver (MgAg) (90:10 w/w) are deposited to form a 13 nm-thick cathode. On the cathode, an arylamine compound is deposited to form an 80 nm-thick optical auxiliary layer and thus manufacture a red light emitting quantum dot device with a top emission typed structure.

Comparative Example 6

A red light emitting quantum dot device with a top emission typed structure is manufactured according to the same method as Example 7 except that a 60 nm-thick hole transport layer is formed.

Comparative Example 7

A red light emitting quantum dot device with a bottom emission typed structure is manufactured according to the same method as Example 7 except that ITO is used to form a 150 nm-thick ITO anode (transparent anode) instead of the ITO/Ag/ITO anode, and aluminum instead of the magnesium-silver is used to form a 120 nm-thick cathode (reflective cathode) is formed.

Evaluation II

Light emitting characteristics of the red light emitting quantum dot devices according to Example 7 and Comparative Examples 6 and 7 are evaluated.
The results are shown in Table 3.

Table 3

| | Example 7 | Comparative Example 6 | Comparative Example 7 |
|---|---|---|---|
| $EQE_{max}$ (%) | 29.7 | 4.8 | 21.0 |
| EQE@5000nit | 27.1 | 4.7 | 19.1 |
| EQE@420mA/cm$^2$ | 22.3 | 3.4 | 11.0 |
| $Cd/A_{max}$ | 37.6 | 4.6 | 25.1 |
| $\lambda_{max}$ (nm) | 628 | 633 | 629 |
| FWHM (nm) | 31 | 39 | 36 |
| $CIE_x$ | 0.6910 | 0.696 | 0.6890 |
| $CIE_y$ | 0.3090 | 0.304 | 0.3110 |
| * EQE@5000 nit: External quantum efficiency at 5000 nit<br>* EQE@420 mA/cm$^2$: External quantum efficiency at 420 mA/cm$^2$<br>* $Cd/A_{max}$: maximum current efficiency | | | |

Referring to Table 3, the red light emitting quantum dot device according to Example 7 exhibits high luminous efficiency, improved current characteristics, and a narrow full width at half maximum (FWHM), compared with the red light emitting quantum dot devices according to Comparative Examples 6 and 7.

<u>Evaluation III</u>

Life-span characteristics of the red light emitting quantum dot devices according to Example 7 and Comparative Examples 6 and 7 are evaluated.

The life-span characteristics are evaluated from a reduced amount of luminance relative to the initial luminance by injecting a current suitable for the condition that the luminance of the quantum dot device is 4500 nit, and T90 is time when 90% of luminance relative to the initial luminance is reduced.

The results are shown in Table 4.

Table 4

|  | $T_{90}$ (h) |
|---|---|
| Example 7 | 60 |
| Comparative Example 6 | < 5 |
| Comparative Example 7 | < 30 |

Referring to Table 4, the red light emitting quantum dot device according to Example 7 exhibits improved life-span characteristics, compared with the red light emitting quantum dot devices of Comparative Examples 6 and 7.

While this disclosure has been described in connection with what is presently considered to be practical example embodiments, it is to be understood that the invention is not limited to the disclosed embodiments.,The scope of protection shall be defined by the appended claims.

**Claims**

1. A quantum dot device (10B), consisting of:

an anode (11B) disposed on the substrate (110), the anode comprising a reflective layer,
a hole auxiliary layer (14B) disposed on the anode, the hole auxiliary layer consisting of a hole injection layer (14a) and a hole transport layer (14b),
a quantum dot layer (13B) disposed on the hole auxiliary layer, the quantum dot layer including quantum dots,
an electron transport layer (15B) disposed on the quantum dot layer, and
a cathode (12B) disposed on the electron transport layer, the cathode being a light-transmitting electrode configured to transmit at least a portion of light emitted from the quantum dot layer, and
optionally an optical auxiliary layer 16B disposed on the cathode,
wherein the quantum dot layer is configured to emit light of a first wavelength spectrum that is one of a blue wavelength spectrum, a green wavelength spectrum, and a red wavelength spectrum,
the hole auxiliary layer has a thickness in which a resonant wavelength of the quantum dot device falls within the first wavelength spectrum,
a peak emission wavelength of the quantum dot layer and a peak emission wavelength of the light passing through the cathode belong to the first wavelength spectrum in common, and
a full width at half maximum, **FWHM,** of the emission spectrum of light passing through the cathode is narrower than that of the emission spectrum of the quantum dot layer, and
wherein:

the first wavelength spectrum is a blue wavelength spectrum,
a thickness of the hole auxiliary layer is 100 nm to 160 nm,
a thickness of the electron transport layer is greater than or equal to 5 nm and less than 80 nm, and
a total thickness of the hole auxiliary layer, the quantum dot layer, and the electron trasnport layer is 160 nm to 230 nm.

2. The quantum dot device of claim 1, wherein the hole auxiliary layer is thicker than the electron transport layer.

3. The quantum dot device of claim 1 or 2, wherein

the quantum dots comprise cadmium-free quantum dots, and

a difference between a refractive index of the quantum dot layer and a refractive index of the electron transport layer is 0.20 to 1.0.

4. A quantum dot device (10R), consisting of:

an anode (11R) disposed on the substrate (110), the anode comprising a reflective layer,
a hole auxiliary layer (14R) disposed on the anode, the hole auxiliary layer consisting of a hole injection layer (14a) and a hole transport layer (14b),
a quantum dot layer (13R) disposed on the hole auxiliary layer, the quantum dot layer including quantum dots,
an electron transport layer (15R) disposed on the quantum dot layer,
a cathode (12R) disposed on the electron transport layer, the cathode being a light-transmitting electrode configured to transmit at least a portion of light emitted from the quantum dot layer, and
optionally an optical auxiliary layer 16R disposed on the cathode,
wherein the quantum dot layer is configured to emit light of a first wavelength spectrum that is one of a blue wavelength spectrum, a green wavelength spectrum, and a red wavelength spectrum,
the hole auxiliary layer has a thickness in which a resonant wavelength of the quantum dot device falls within the first wavelength spectrum,
a peak emission wavelength of the quantum dot layer and a peak emission wavelength of the light passing through the cathode belong to the first wavelength spectrum in common, and
a full width at half maximum, FWHM, of the emission spectrum of light passing through the cathode is narrower than that of the emission spectrum of the quantum dot layer, and
wherein:

the first wavelength spectrum is a red wavelength spectrum,
a thickness of the hole auxiliary layer is 40 nm to 70 nm or 230 nm to 280 nm,
a thickness of the electron transport layer is greater than or equal to 5 nm and less than 80 nm, and
a total thickness of the hole auxiliary layer, the quantum dot layer, and the electron transport layer is 90 nm to 120 nm or 270 nm to 330 nm.

5. The quantum dot device of any preceding claim, wherein the electron transport layer comprises alkaline earth metal-containing inorganic nanoparticles.

6. The quantum dot device of any preceding claim, wherein a difference between the peak emission wavelength of the quantum dot layer and the peak emission wavelength of light passing through the cathode is ±5 nm.

7. The quantum dot device of any preceding claim, wherein the full width at half maximum, FWHM, of the emission spectrum of light passing through the cathode is 0.2 times to 0.9 times of the FWHM of the emission spectrum of the quantum dot layer.

8. A quantum dot display device comprising the quantum dot device of any preceding claim.


**Patentansprüche**

1. Quantenpunktvorrichtung (10B), bestehend aus:

einer Anode (11B), die auf dem Substrat (110) angeordnet ist, wobei die Anode eine reflektierende Schicht umfasst,
einer auf der Anode angeordneten Lochhilfsschicht (14B), wobei die Lochhilfsschicht aus einer Lochinjektionsschicht (14a) und einer Lochleitungsschicht (14b) besteht,
einer Quantenpunktschicht (13B), die auf der Lochhilfsschicht angeordnet ist, wobei die Quantenpunktschicht Quantenpunkte enthält,
einer Elektronenleitungsschicht (15B), die auf der Quantenpunktschicht angeordnet ist, und
einer Kathode (12B), die auf der Elektronenleitungsschicht angeordnet ist, wobei die Kathode eine lichtdurchlässige Elektrode ist, die dazu konfiguriert ist, mindestens einen Teil von Licht, das von der Quantenpunktschicht emittiert wird, durchzulassen, und
optional einer auf der Kathode angeordneten optischen Hilfsschicht 16B,

wobei die Quantenpunktschicht dazu konfiguriert ist, Licht eines ersten Wellenlängenspektrums zu emittieren, das eines von einem blauen Wellenlängenspektrum, einem grünen Wellenlängenspektrum und einem roten Wellenlängenspektrum ist,

die Lochhilfsschicht eine Dicke aufweist, in der eine Resonanzwellenlänge der Quantenpunktvorrichtung innerhalb des ersten Wellenlängenspektrums liegt,

eine Spitzenemissionswellenlänge der Quantenpunktschicht und eine Spitzenemissionswellenlänge des durch die Kathode hindurchtretenden Lichts gemeinsam zu dem ersten Wellenlängenspektrum gehören und

eine Halbwertsbreite, FWHM, des Emissionsspektrums des durch die Kathode hindurchtretenden Lichts schmaler ist als diejenige des Emissionsspektrums der Quantenpunktschicht und

wobei:

das erste Wellenlängenspektrum ein blaues Wellenlängenspektrum ist,
eine Dicke der Lochhilfsschicht 100 nm bis 160 nm beträgt,
eine Dicke der Elektronenleitungsschicht mehr als oder gleich 5 nm und weniger als 80 nm beträgt und
eine Gesamtdicke der Lochhilfsschicht, der Quantenpunktschicht und der Elektronenleitungsschicht 160 nm bis 230 nm beträgt.

2. Quantenpunktvorrichtung nach Anspruch 1, wobei die Lochhilfsschicht dicker als die Elektronenleitungsschicht ist.

3. Quantenpunktvorrichtung nach Anspruch 1 oder 2, wobei

die Quantenpunkte cadmiumfreie Quantenpunkte umfassen und
eine Differenz zwischen einem Brechungsindex der Quantenpunktschicht und einem Brechungsindex der Elektronenleitungsschicht 0,20 bis 1,0 beträgt.

4. Quantenpunktvorrichtung (10R), bestehend aus:

einer Anode (11R), die auf dem Substrat (110) angeordnet ist, wobei die Anode eine reflektierende Schicht umfasst,
einer auf der Anode angeordneten Lochhilfsschicht (14R), wobei die Lochhilfsschicht aus einer Lochinjektionsschicht (14a) und einer Lochleitungsschicht (14b) besteht,
einer Quantenpunktschicht (13R), die auf der Lochhilfsschicht angeordnet ist, wobei die Quantenpunktschicht Quantenpunkte enthält,
einer Elektronenleitungsschicht (15R), die auf der Quantenpunktschicht angeordnet ist,
einer Kathode (12R), die auf der Elektronenleitungsschicht angeordnet ist, wobei die Kathode eine lichtdurchlässige Elektrode ist, die dazu konfiguriert ist, mindestens einen Teil von Licht, das von der Quantenpunktschicht emittiert wird, durchzulassen, und
optional einer auf der Kathode angeordneten optischen Hilfsschicht 16R,
wobei die Quantenpunktschicht dazu konfiguriert ist, Licht eines ersten Wellenlängenspektrums zu emittieren, das eines von einem blauen Wellenlängenspektrum, einem grünen Wellenlängenspektrum und einem roten Wellenlängenspektrum ist,
die Lochhilfsschicht eine Dicke aufweist, in der eine Resonanzwellenlänge der Quantenpunktvorrichtung innerhalb des ersten Wellenlängenspektrums liegt,
eine Spitzenemissionswellenlänge der Quantenpunktschicht und eine Spitzenemissionswellenlänge des durch die Kathode hindurchtretenden Lichts gemeinsam zu dem ersten Wellenlängenspektrum gehören und
eine Halbwertsbreite, FWHM, des Emissionsspektrums des durch die Kathode hindurchtretenden Lichts schmaler ist als diejenige des Emissionsspektrums der Quantenpunktschicht und
wobei:

das erste Wellenlängenspektrum ein rotes Wellenlängenspektrum ist,
eine Dicke der Lochhilfsschicht 40 nm bis 70 nm oder 230 nm bis 280 nm beträgt,
eine Dicke der Elektronenleitungsschicht mehr als oder gleich 5 nm und weniger als 80 nm beträgt und
eine Gesamtdicke der Lochhilfsschicht, der Quantenpunktschicht und der Elektronenleitungsschicht 90 nm bis 120 nm oder 270 nm bis 330 nm beträgt.

5. Quantenpunktvorrichtung nach einem vorhergehenden Anspruch, wobei die Elektronenleitungsschicht Erdalkalimetall-enthaltende anorganische Nanopartikel umfasst.

**6.** Quantenpunktvorrichtung nach einem vorhergehenden Anspruch, wobei eine Differenz zwischen der Spitzenemissionswellenlänge der Quantenpunktschicht und der Spitzenemissionswellenlänge des durch die Kathode hindurchtretenden Lichts $\pm 5$ nm beträgt.

**7.** Quantenpunktvorrichtung nach einem vorhergehenden Anspruch, wobei die Halbwertsbreite, FWHM, des Emissionsspektrums des durch die Kathode hindurchtretenden Lichts das 0,2-Fache bis 0,9-Fache des FWHM des Emissionsspektrums der Quantenpunktschicht beträgt.

**8.** Quantenpunktanzeigevorrichtung, umfassend die Quantenpunktvorrichtung nach einem vorhergehenden Anspruch.

**Revendications**

**1.** Dispositif à points quantiques (10B), constitué de :

une anode (11B) disposée sur le substrat (110), l'anode comprenant une couche réfléchissante,
une couche auxiliaire de trous (14B) disposée sur l'anode, la couche auxiliaire de trous étant constituée d'une couche d'injection de trous (14a) et d'une couche de transport de trous (14b),
une couche de points quantiques (13B) disposée sur la couche auxiliaire de trous, la couche de points quantiques comprenant des points quantiques,
une couche de transport d'électrons (15B) disposée sur la couche de points quantiques, et
une cathode (12B) disposée sur la couche de transport d'électrons, la cathode étant une électrode de transmission de lumière conçue pour transmettre au moins une partie de la lumière émise par la couche de points quantiques, et
éventuellement une couche auxiliaire optique 16B disposée sur la cathode,
ladite couche de points quantiques étant conçue pour émettre de la lumière d'un premier spectre de longueurs d'onde qui est l'un d'un spectre de longueurs d'onde bleu, d'un spectre de longueurs d'onde vert et d'un spectre de longueurs d'onde rouge,
ladite couche auxiliaire de trous possédant une épaisseur dans laquelle une longueur d'onde de résonance du dispositif à points quantiques se trouve dans le premier spectre de longueurs d'onde,
une longueur d'onde d'émission de pic de la couche de points quantiques et une longueur d'onde d'émission de pic de la lumière traversant la cathode appartenant au premier spectre de longueurs d'onde en commun, et
une largeur totale à mi-hauteur, LTMH, du spectre d'émission de lumière traversant la cathode étant plus étroite que celle du spectre d'émission de la couche de points quantiques, et :

ledit premier spectre de longueurs d'onde étant un spectre de longueurs d'onde bleu,
une épaisseur de la couche auxiliaire de trous étant de 100 nm à 160 nm,
une épaisseur de la couche de transport d'électrons étant supérieure ou égale à 5 nm et inférieure à 80 nm, et
une épaisseur totale de la couche auxiliaire de trous, de la couche de points quantiques, et
de la couche de transport d'électrons étant de 160 nm à 230 nm.

**2.** Dispositif à points quantiques de la revendication 1, ladite couche auxiliaire de trous étant plus épaisse que la couche de transport d'électrons.

**3.** Dispositif à points quantiques de la revendication 1 ou 2, lesdits points quantiques comprenant des points quantiques sans cadmium, et une différence entre un indice de réfraction de la couche de points quantiques et un indice de réfraction de la couche de transport d'électrons étant de 0,20 à 1,0.

**4.** Dispositif à points quantiques (10R), constitué de :

une anode (11R) disposée sur le substrat (110), l'anode comprenant une couche réfléchissante,
une couche auxiliaire de trous (14R) disposée sur l'anode, la couche auxiliaire de trous étant constituée d'une couche d'injection de trous (14a) et d'une couche de transport de trous (14b),
une couche de points quantiques (13R) disposée sur la couche auxiliaire de trous, la couche de points quantiques comprenant des points quantiques,
une couche de transport d'électrons (15R) disposée sur la couche de points quantiques,
une cathode (12R) disposée sur la couche de transport d'électrons, la cathode étant une électrode de transmission de lumière conçue pour transmettre au moins une partie de la lumière émise par la couche de points quantiques, et

éventuellement une couche auxiliaire optique 16R disposée sur la cathode, ladite couche de points quantiques étant conçue pour émettre de la lumière d'un premier spectre de longueurs d'onde qui est l'un d'un spectre de longueurs d'onde bleu, d'un spectre de longueurs d'onde vert et d'un spectre de longueurs d'onde rouge, ladite couche auxiliaire de trous possédant une épaisseur dans laquelle une longueur d'onde de résonance du dispositif à points quantiques se trouve dans le premier spectre de longueurs d'onde, une longueur d'onde d'émission de pic de la couche de points quantiques et une longueur d'onde d'émission de pic de la lumière traversant la cathode appartenant au premier spectre de longueurs d'onde en commun, et une largeur totale à mi-hauteur, LTMH, du spectre d'émission de lumière traversant la cathode étant plus étroite que celle du spectre d'émission de la couche de points quantiques, et :

ledit premier spectre de longueurs d'onde étant un spectre de longueurs d'onde rouge, une épaisseur de la couche auxiliaire de trous étant de 40 nm à 70 nm ou de 230 nm à 280 nm, une épaisseur de la couche de transport d'électrons étant supérieure ou égale à 5 nm et inférieure à 80 nm, et une épaisseur totale de la couche auxiliaire de trous, de la couche de points quantiques et de la couche de transport d'électrons étant de 90 nm à 120 nm ou de 270 nm à 330 nm.

5. Dispositif à points quantiques d'une quelconque revendication précédente, ladite couche de transport d'électrons comprenant des nanoparticules inorganiques contenant un métal alcalino-terreux.

6. Dispositif à points quantiques d'une quelconque revendication précédente, une différence entre la longueur d'onde d'émission de pic de la couche de points quantiques et la longueur d'onde d'émission de pic de la lumière traversant la cathode étant de ±5 nm.

7. Dispositif à points quantiques d'une quelconque revendication précédente, ladite largeur totale à mi-hauteur, LTMH, du spectre d'émission de lumière traversant la cathode étant de 0,2 fois à 0,9 fois la LTMH du spectre d'émission de la couche de points quantiques.

8. Dispositif d'affichage à points quantiques comprenant le dispositif à points quantiques d'une quelconque revendication précédente.

FIG. 1

FIG. 2

EP 3 920 251 B1

200

PX1 PX2 PX3

III

III

PX

. . .

. . .

EP 3 920 251 B1

## FIG. 3

FIG. 4

FIG. 5

FIG. 6

FIG. 7

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN 110400890

**Non-patent literature cited in the description**

• **LIU SHIHAO et al.** *Top-emitting quantum dots light-emitting devices employing microcontact printing with electricfield-independent emission*, 02 March 2016

• **LIU GUOHONG et al.** *Very bright and Efficient Microcavity Top-Emitting Quantum Dot Light-emitting Diodes with Ag Electordes*, 24 June 2016
• **LI DONG et al.** *Enhanced Efficiency on In-P-Based Red Quantum Dot Light-Emitting Diodes*, 23 August 2019